# EUROPEAN PATENT APPLICATION

(11) **EP 4 518 024 A1**
(43) Date of publication of application: **05.03.2025**
(21) Application number: 22941767.0
(22) Date of filing: 09.05.2022
(51) Int. Cl.: H01Q 1/32, H01Q 1/38, H01Q 5/20, H01Q 1/46, H04B 7/0413

(54) **BROADBAND ANTENNA DISPOSED IN VEHICLE**

(71) Applicant: LG Electronics Inc., Yeongdeungpo-gu Seoul 07336 (KR)
(72) Inventor: YUN, Changwon, Seoul 06772 (KR); KIM, Changil, Seoul 06772 (KR); YOUN, Yeomin, Seoul 06772 (KR); KIM, Yongkon, Seoul 06772 (KR); JEON, Cheolsoo, Seoul 06772 (KR)
(74) Representative: Vossius & Partner Patentanwälte Rechtsanwälte mbB
(86) International application number: PCT/KR2022/006585
(87) International publication number: WO 2023/219180

(57) **Abstract**

An antenna module mounted in a vehicle comprises: a PCB on which electronic components are disposed; and an antenna element connected to a metal pattern on the PCB and configured to radiate a radio signal. The antenna element may include a first conductive part formed perpendicularly to the PCB within a predetermined angle range and having a first metal pattern formed in a roof shape. The antenna element may further include a second conductive part having a second metal pattern formed parallel to the PCB at an upper end of the first metal pattern.

## Description

### CROSS-REFERENCE TO RELATED APPLICATIONS

This application is the National Stage filing under 35 U.S.C. 371 of International Application No. PCT/KR2022/006585 filed on May 9, 2022, which is hereby expressly incorporated by reference into the present application.

### Technical Field

The present disclosure relates a broadband antenna disposed in a vehicle. A particular implementation relates to an antenna module having a broadband antenna to be capable of operating in various communication systems, and to a vehicle having the antenna module.

### Background Art

A vehicle may perform wireless communication services with other vehicles or nearby objects, infrastructures, or a base station. In this regard, various communication services may be provided using long term evolution (LTE) communication, fifth generation (5G) communication, or WiFi communication technology.

In order to provide these various wireless communication services in a vehicle, an antenna may be disposed on glass of the vehicle, above or below a roof of the vehicle. When the antenna is disposed on the glass of the vehicle, it may be implemented with a transparent antenna material. Meanwhile, when the antenna is disposed above or below the roof of the vehicle, an effect on a vehicle body and the roof of the vehicle may cause a change in antenna performance.

In relation to this, since the vehicle body and the vehicle roof are made of a metal material, there is a problem in that radio waves may be blocked. Accordingly, a separate antenna structure may be placed on the vehicle body or the vehicle roof. As another example, an antenna structure may be configured to be placed below a vehicle body or a vehicle roof.

Meanwhile,
to provide a 4G/5G communication service, a vehicle antenna module needs to define a low elevation beam pattern while performing broadband operation in a full band for the 4G/5G communication service. In addition, the as the vehicle antenna module needs to have antennas for global navigation satellite system (GNSS) and Wi-Fi communication mounted in a vehicle to provide GNSS and Wi-Fi communication services. In relation to such a Wi-Fi communication service, a Wi-Fi antenna for a vehicle need to be configured to operate in a 5GHz band in addition to a 2.4GHz band.

In addition, there is a need to provide a wireless communication service in regions outside and inside a vehicle through a vehicle antenna. In relation to this, there is a problem in that it is difficult to provide a wireless signal to an inner region of the vehicle when a vehicle antenna is placed within a roof of the vehicle.

In this regard, the vehicle antenna module may be placed in different locations in the vehicle, e.g., inside (or on) a roof of the vehicle or on an instrument panel (or a dashboard) of the vehicle. In relation to this, the vehicle antenna module may be mounted on the instrument panel inside the vehicle or on the roof outside the vehicle. The vehicle antenna module needs to satisfy antenna performance in different locations in the vehicle with different ground environments.

### Disclosure of Invention

### Technical Problem

The present disclosure is directed to solving the aforementioned problems and other drawbacks. Another aspect of the present disclosure is to provide an antenna structure configured to operate to cover a full low band (LB) for fourth generation (4G)/fifth generation (5G) communication.

Another aspect of the present disclosure is to provide an antenna structure configured to operate to cover a full band including a mid band (MB), a high band (HB) and an ultra-high band (UHB) for 4G/5G communication, in addition to the 4G/5G low band (LB).

Another aspect of the present disclosure is to provide, in one antenna module, an antenna structure configured to operate in a global navigation satellite system (GNSS) band and in a Wi-Fi band, in addition to the 4G/5G full band.

Another aspect of the present disclosure is to provide a wireless signal to an inner region of a vehicle even when a body or a roof exterior of a vehicle is made of a metal material.

Another aspect of the present disclosure is to provide an external antenna for vehicle external communication and an internal antenna for vehicle internal communication, placed in different locations in a vehicle, may be provided as one antenna module.

Another aspect of the present disclosure is to improve antenna performance while maintaining a height of an antenna module at a certain level or less.

Another aspect of the present disclosure is to present a structure for mounting, in a vehicle, an antenna system capable of operating in a broad band to support various communication systems.

### Solution to Problem

To achieve these and other advantages and in accordance with the purpose of the present disclosure, as embodied and broadly described herein, there is provided an antenna module mounted in a vehicle, the antenna module including: a printed circuit board (PCB) on which electronic components are disposed; and an antenna element connected to a metal pattern on the PCB and configured to radiate a radio signal. The antenna element may include a first conductive part disposed to be perpendicular to the PCB within a predetermined angle range and having a first metal pattern in a loop shape. The antenna element may further include a second conductive part having a second metal pattern disposed at an upper end of the first metal pattern to be parallel with the PCB.

According to an embodiment, the antenna element may be configured to radiate a first signal in a first band through the first conductive part. The antenna element may be configured to radiate a second signal in a second band other than the first band through the first conductive part. The antenna element may be configured to radiate a first signal in a band between the first band and the second through the first conductive part and the second conductive part. As one example, the second band may be configured as a band higher than the first band.

According to an embodiment, the antenna module may include a lower cover disposed below the PCB and made of a metal plate. The antenna module may include an upper cover combined with the lower cover and configured to accommodate the PCB and the antenna element therein.

According to an embodiment, the antenna element may include a feeding structure configured to extend from an upper end of a first separation point of a lower pattern of the first metal pattern to be connected to a signal pattern of the PCB. The antenna element may further include a short-circuit structure configured to extend from an upper end of a second separation point of the lower pattern of the first metal pattern to be connected to a ground pattern of the PCB.

According to an embodiment, the feeding structure may include a first feed pattern disposed to extend from an upper end of a first separation point of a lower pattern of the first metal pattern to be parallel with the PCB. The feeding structure may further include a second feed pattern disposed at an end of the first feeding pattern to be perpendicular to the first feed pattern. The feeding structure may further include a third feed pattern disposed at an end of the second feed pattern to be perpendicular to the second feed pattern and configured to be connected to a signal pattern of the PCB.

According to an embodiment, a first slot region may be disposed in an upper pattern of the first metal pattern to have a second length greater than a first length of a gap in the lower pattern. A second slot region may be disposed in one region of the second metal pattern connected to the upper pattern of the first metal pattern to have a third length equal to or greater than the second length

According to an embodiment, a length of the lower pattern of the first metal line of the first conductive part may be determined so that the antenna element operates in a low band (LB). A sum of the length of the lower pattern and a side length of the first metal line may be determined so that the antenna element operates in a mid band (MB).

According to an embodiment, a length of one side of the lower pattern of the first metal line may be determined so that the antenna element operates in a fifth generation (5G) Sub-6 band. A distance between the lower pattern and the upper pattern of the first metal line may be determined so that the antenna element operates in a high band (HB).

According to an embodiment, the second conductive part may include a first metal region disposed to be connected to the first metal line and configured to have a first width and a first length. The second conductive part may further include a second metal region configured to have a second width smaller than the first width. A total length of the first metal region and the second metal region may be configured as a second length. The first length and the second length may be determined so that the antenna element operates in a mid band (MB) and a low band (LB), respectively.

According to an embodiment, the antenna element may be configured to radiate a first signal at a first frequency in the first band through the second conductive part. The antenna element may be configured to radiate a signal at a second frequency higher than the first frequency in the first band through the first conductive part and the second conductive part. The first band may be a low band (LB), and the second band may include a mid band (MB) and a high band (HB).

According to an embodiment, the antenna element may further include a third conductive part disposed on the PCB and configured to radiate a third signal in a third band higher than the second band. The antenna element may be configured to radiate a third signal at a first frequency in the third band through the first conductive part and the third conductive part. The antenna element may be configured to radiate a third signal at a second frequency higher than the first frequency in the third band through the third conductive part. The antenna element may be configured to radiate a third signal at a second frequency higher than the first frequency in the third band through the third conductive part.

According to an embodiment, the antenna element may operate as a first antenna disposed on one side region of the PCB, and the second conductive part of the first antenna may be disposed to be bent at an upper end of the first metal pattern in one direction. The antenna module may further include a second antenna disposed on another side region of the PCB to have a structure symmetrical to the first antenna.

According to an embodiment, the second antenna may include a first conductive part disposed to be perpendicular to the PCB within a predetermined angle range and configured to have a first metal pattern in a loop shape. The second antenna may further include a second conductive part disposed to be bent at an upper end of the first metal pattern in another direction opposite to the one direction and having a second metal pattern to be parallel with the PCB.

According to an embodiment, the antenna module may include a global navigation satellite system (GNSS) antenna disposed to be apart from one side end of a second radiation structure of the first antenna and including an upper radiator and a connection portion perpendicularly connected to the upper radiator. The antenna module may further include a Wi-Fi antenna disposed between the first antenna and the GNSS antenna, and configured as a side surface radiator.

According to an embodiment, the antenna module may further include a network access device (NAD) disposed on the PCB to be adjacent to the first antenna and operably coupled to the first antenna and the second antenna. When quality of a signal received from the first antenna is equal to or less than a threshold value, the NAD applies a signal to the second antenna to receive a signal through the second antenna.

According to an embodiment, the NAD may perform multiple input/output (MIMO) or diversity operation in the first band through the first antenna and the second antenna. When quality of the first signal in the first band is equal to or below a threshold value, the NAD may perform MIMO or diversity operation in the second band through the first antenna and the second antenna.

According to an embodiment, the antenna module may further include a backup battery disposed in the upper cover and configured to supply power to inside of the antenna module. The first antenna may be disposed to be adjacent to one side of an accommodation space of the backup battery. The second antenna is located in a lower region of the accommodation space to be disposed to be offset to a lower region further than the first antenna.

According to an embodiment, the antenna module may further include a dielectric mold attached to regions of the lower cover in correspondence with a first region and a second region on the PCB, respectively, wherein the first antenna and the second antenna are disposed in the first region and the second region, respectively. Metal in lower portions of the first antenna and the second antenna may configured to be apart from ground by the dielectric mold.

According to another aspect of the present specification, there is also provided a vehicle including an antenna module disposed below a roof of the vehicle; and a processor disposed inside or outside the antenna module and configured to communicate with at least one of an adjacent vehicle, a road side unit (RSU), and a base station. The antenna element may include a printed circuit board (PCB) on which electronic components are disposed and an antenna element connected to a metal pattern on the PCB and configured to radiate a radio signal. The antenna element may include a first conductive part disposed to be perpendicular to the PCB within a predetermined angle range and having a first metal pattern in a loop shape.

According to an embodiment, the antenna module may include a lower cover disposed below the PCB and made of a metal plate. The antenna module may include an upper cover combined with the lower cover and configured to accommodate the PCB and the antenna element therein.

According to an embodiment, the antenna element may further include a second conductive part having a second metal pattern disposed at an upper end of the first metal pattern to be parallel with the PCB. The antenna element may be configured to radiate a first signal in a first band through the second conductive part. The antenna element may be configured to radiate a second signal in a second band other than the first band through the first conductive part. As one example, the second band may be configured as a band higher than the first band.

According to an embodiment, the antenna element may further include a feeding structure configured to extend from an upper end of a first separation point of a lower pattern of the first metal pattern to be connected to a signal pattern of the PCB. The antenna element may further include a short-circuit structure configured to extend from an upper end of a second separation point of the lower pattern of the first metal pattern to be connected to a ground pattern of the PCB.

According to an embodiment, the antenna element may operate as a first antenna disposed on one side region of the PCB, and the second conductive part of the first antenna may be disposed to be bent at an upper end of the first metal pattern in one direction. The vehicle may further include a second antenna disposed on another side region of the PCB to have a structure symmetrical to the first antenna. The second antenna may include a first conductive part disposed to be perpendicular to the PCB within a predetermined angle range and configured to have a first metal pattern in a loop shape. The second antenna may include a second conductive part disposed to be bent at an upper end of the first metal pattern in another direction opposite to the one direction and having a second metal pattern to be parallel with the PCB.

According to an embodiment, the processor may be disposed on the PCB to be adjacent to the first antenna and operably coupled to the first antenna and the second antenna. when quality of a signal received from the first antenna is equal to or less than a threshold value, the processor applies a signal to the second antenna to receive a signal through the second antenna. When quality of a signal received from the first antenna is equal to or less than a threshold value, the processor may apply a signal to the second antenna to receive a signal through the second antenna.

According to an embodiment, the processor may perform multiple input/output (MIMO) or diversity operation in the first band through the first antenna and the second antenna. When quality of the first signal in the first band is equal to or below a threshold value, the processor may perform MIMO or diversity operation in the second band through the first antenna and the second antenna.

### Advantageous Effects of Invention

Hereinafter, technical effects of an antenna module having a broadband antenna mounted in a vehicle and the vehicle having the antenna module mounted thereon are described below.

According to the present disclosure, operation may be performed to cover a full 4G/5G low band (LB) through a conductive part having a loop shape.

According to the present disclosure, operation may be performed to cover a full band including a mid band (MB), a high band (HB), and a very high band (VHB) in addition to the low band (LB) for 4G/5G communication through a first conductive part having a loop shape and a second conductive part having a patch shape. The second conductive part may be disposed to be substantially perpendicularly bent from the first conductive part to be parallel with a printed circuit board (PCB).

According to the present disclosure, a conductive part operating in a global navigation satellite system (GNSS) band and in a Wi-Fi band in addition to a 4G/5G full band may be provided in one antenna module. A GNSS antenna and a Wi-Fi antenna may be disposed in a region adjacent to at least one of first and second antennas operating in a full 4G/5G band.

According to the present disclosure, even when a body or a roof exterior of the vehicle is made of a metal material, an antenna module may be disposed to provide a wireless signal to an inner region of a vehicle. Some part of an upper cover of the antenna module and a roof structure of the vehicle may be made of a non-metal material.

According to the present disclosure, an external antenna for vehicle external communication and an internal antenna for vehicle internal communication, placed in different locations in a vehicle, may be provided as one antenna module. An antenna element disposed in the antenna module may be configured such that a first conductive part configured to define a low elevation beam pattern is combined with a second conductive part configured to define a bore-sight beam pattern.

According to the present disclosure, antenna performance may be improved while maintaining a height of an antenna module at a certain level or less. A height of a whole antenna module may be reduced by lowering a height of a first conductive part having a loop shape.

According to the present disclosure, a structure for mounting, in a vehicle, an antenna system capable of operating in a broad band to support various communication systems is provided. In relation to this, MIMO or diversity operation may be performed through first and second antennas configured to operate to cover a full 4G/5G communication band. A GNSS antenna and A Wi-Fi antenna may be placed to be adjacent to one of the first and second antennas.

Further scope of applicability of the present disclosure will become apparent from the foregoing detailed description. It should be understood, however, that the detailed description and specific examples, such as the preferred embodiment of the present disclosure, are given by way of illustration only, since various modifications and alternations within the spirit and scope of the disclosure will be apparent to those skilled in the art.

### Brief Description of Drawings

FIG. 1A is a diagram illustrating an internal configuration of a vehicle in accordance with one example. FIG. 1B is a lateral view illustrating the vehicle interior in accordance with the one example.
FIG. 2A illustrates types of vehicle-to-everything (V2X) applications.
FIG. 2B illustrates a standalone scenario supporting V2X sidelink (SL) communication and a multi-radio dual connectivity (MR-DC) scenario supporting V2X SL communication.
FIGS. 3A to 3C are views illustrating a structure for mounting an antenna system in a vehicle, to which the antenna system is mounted.
FIG. 4 is a block diagram illustrating a vehicle and an antenna system mounted to the vehicle in accordance with one example.
FIG. 5 is an exploded perspective view of a vehicle antenna module according to the present disclosure.
FIG. 6 illustrates a structure in which antenna elements are disposed on an upper cover in the vehicle antenna module of FIG. 5.
FIG. 7 illustrates an equivalent antenna structure related to broadband operation of an antenna element according to the present disclosure.
FIG. 8 is a side perspective view of an antenna element according to the present disclosure.
FIGS. 9A to 10B illustrate a first side view, a second side view, a front view, and a third side view of the antenna element of FIG. 8, respectively.
FIG. 11 shows a conductive part arranged on a printed circuit board (PCB) of the vehicle antenna module in the present disclosure.
FIGS. 12A to 12C illustrate electric field distributions in a region in which an antenna element is disposed and a peripheral region according to each frequency band.
FIG. 13A to 14B illustrate electric field distributions in a region in which an antenna element is arranged and a peripheral region according to each band of frequencies equal to or higher than a particular frequency.
FIG. 15A illustrates an antenna module 1000a that may be placed on or inside a roof of a vehicle, and a required low elevation beam pattern.
FIG. 15B illustrates an antenna module 1000b that may be placed on a dashboard or an instrument panel of a vehicle, and a required bore-sight beam pattern.
FIG. 16A illustrates a configuration of a vehicle in which antenna modules having a roof top mounting structure and an instrument panel mounting structure according to the present disclosure are disposed.
FIG. 16B illustrates an antenna equivalent structure of the antenna modules having the roof top mounting structure and the instrument panel mounting structure.
17A and 17B show antenna efficiencies for each frequency with respect to each antenna element in the vehicle antenna module according to the present disclosure.
FIGS. 18A and 18B illustrate a VSWR for each frequency with respect to each antenna element in the vehicle antenna module according to the present disclosure.
FIG. 19 illustrates a block diagram of a vehicle antenna module configured to include an external antenna and an internal antenna.
Meanwhile, FIG. 20 is a block diagram illustrating an antenna module according to an embodiment and a vehicle on which the antenna module is mounted.

### Mode for the Invention

A description will now be given in detail according to exemplary embodiments disclosed herein, with reference to the accompanying drawings. For the sake of a brief description with reference to the drawings, the same or equivalent components may be provided with the same or similar reference numbers, and the description thereof will not be repeated. A suffix "module" or "unit" used for elements disclosed in the following description is merely intended for easy description of the specification, and the suffix itself is not intended to give any special meaning or function. In describing the disclosure, if a detailed explanation for a related known function or construction is considered to unnecessarily divert the gist of the disclosure, such explanation has been omitted but would be understood by those skilled in the art. The accompanying drawings are used to help easily understand the technical idea of the disclosure and it should be understood that the idea of the disclosure is not limited by the accompanying drawings. The idea of the disclosure should be construed to extend to any alterations, equivalents, and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element may be connected with the another element or intervening elements may also be present. In contrast, when an element is referred to as being "directly connected with" another element, there are no intervening elements present.

A singular representation may include a plural representation unless it represents a definitely different meaning from the context.

Terms "include" or "has" as used herein should be understood that they are intended to indicate the existence of a feature, a number, a step, an element, a component or a combination thereof disclosed in the specification, and it may also be understood that the existence or additional possibility of one or more other features, numbers, steps, elements, components or combinations thereof are not excluded in advance.

An antenna system described herein may be mounted on a vehicle. Configurations and operations according to embodiments may also be applied to a communication system, namely, an antenna system mounted on a vehicle. In this regard, the antenna system mounted on the vehicle may include a plurality of antennas, and a transceiver circuitry and a processor that control the plurality of antennas.

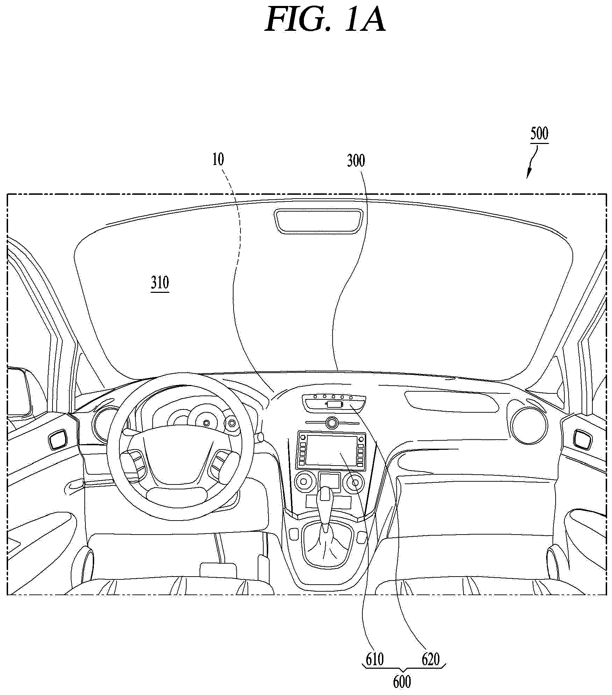

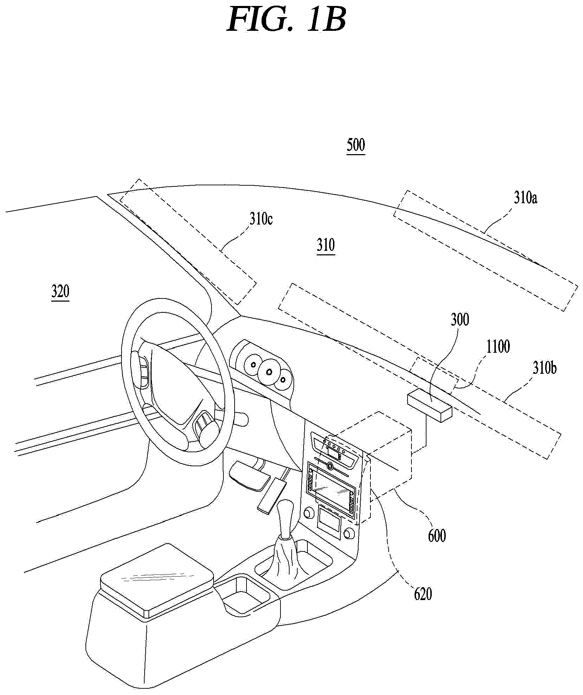

FIG. 1A is a diagram illustrating an internal configuration of a vehicle in accordance with one example. FIG. 1B is a lateral view illustrating the vehicle interior in accordance with the one example.

Referring to FIGS. 1A and 1B, the present disclosure relates to an antenna unit 1000 (i.e., an internal antenna system) capable of transceiving a signal through a global positioning system (GPS), fourth generation (4G) wireless communication, fifth generation (5G) wireless communication, Bluetooth, or a wireless local area network (LAN). Accordingly, the antenna unit (i.e., an antenna system)1000 capable of supporting such various communication protocols may be referred to as an integrated antenna module 1000. The antenna system 1000 may be configured to include a telematics control unit (TCU) 300 (a telematics module) and an antenna assembly 1100. As one example, the antenna assembly 1100 may be placed on a window of the vehicle.

In addition, the present disclosure also relates to a vehicle 500 including the antenna system 1000. The vehicle 500 may be configured to include a housing 10 including a dashboard, the TCU 300, etc. Additionally, the vehicle 500 may be configured to include a mounting bracket configured to mount the TCU 300.

The vehicle 500 according to the present disclosure includes the TCU 300 and an infotainment unit 600 configured to be connected thereto. A part of a front pattern of the infotainment unit 600 may be implemented in a form of a dashboard of the vehicle. The dashboard of the vehicle may be configured to include a display 610 and an audio unit 620.

Meanwhile, the antenna assembly 1100 disclosed herein, i.e., the antenna module 1100 in a form of a transparent antenna may be placed in at least one of an upper region 310a, a lower region 310b, and a side surface region 320 of a front window 310. In addition, the antenna assembly 1100 disclosed herein may be disposed on a side window 320 on a side surface of the vehicle, other than the front window 310.

As illustrated in FIG. 1B, when positioned in the lower region 310b of the front window 310, the antenna assembly 1100 may be operably combined with the TCU 300 placed inside the vehicle. When placed in the upper region 310a or the side surface region 310c of the front window 310, the antenna assembly 1100 may be operably combined with a TCU outside the vehicle. However, the present disclosure is not limited to a TCU combination structure inside or outside the vehicle.

### <V2X (Vehicle-to-Everything)>

Vehicle-to-everything (V2X) communication includes communication between a vehicle and each of all entities, such as vehicle-to-vehicle (V2V) communication which refers to communication between vehicles, vehicle-to-infrastructure (V2I) communication which refers to communication between a vehicle and an eNB or a road side unit (RSU), vehicle-to-pedestrian (V2P) communication which refers to communication between a vehicle and a terminal carried by a person (a pedestrian, a cyclist, a vehicle driver, or a passenger), vehicle-to-network (V2N) communication, and the like.

V2X communication may have the same meaning as V2X sidelink or NR V2X or may have, in a broader sense, a meaning including V2X sidelink or NR V2X.

V2X communication may be applicable to various services, for example, forward collision warning, an automatic parking assist system, cooperative adaptive cruise control (CACC), control-loss warning, traffic queuing warning, traffic vulnerable-area safety warning, emergency vehicle warning, curved-road driving speed warning, and traffic flow control.

V2X communication may be provided through a PC5 interface and/or a Uu interface. In this case, specific network entities for supporting communications between a vehicle and all entities may exist in a wireless communication system supporting V2X communication. For example, the network entity may include a base station (eNB), a road side unit (RSU), a terminal, or an application server (e.g., a traffic safety server).

In addition, a terminal performing V2X communication may refer to not only a general handheld UE but also a vehicle UE (V-UE), a pedestrian UE, an eNB type RSU, a UE type RSU, a robot equipped with a communication module, and the like.

V2X communication may be performed directly between terminals or may be performed through the network entity (entities). V2X operation modes may be classified according to a method of performing such V2X communication.

Terms used in V2X communication may be defined as follows.

A road side unit (RSU) is a V2X service enabled device that may transmit and receive data to and from a moving vehicle using a V2I service. The RSU also serves as a stationary infrastructure entity that supports V2X application programs, and may exchange messages with other entities that support V2X application programs. The RSU is a term frequently used in existing ITS specifications, and the reason for employing the term RSU in association with the 3GPP specifications is to read relevant documents in an easier manner in the ITS industry. The RSU is a logical entity that combines a V2X application logic with the functionality of an eNB (referred to as an eNB-type RSU) or a UE (referred to as a UE-type RSU).

A V2I Service is a type of V2X service, where one party is a vehicle whereas the other party is an entity belonging to an infrastructure. A V2P Service is also a type of V2X service, where one party is a vehicle and the other party is a device carried by a person (e.g., a portable terminal carried by a pedestrian, a cyclist, a driver, or an occupant other than a driver). A V2X Service is a type of 3GPP communication service that involves a transmitting or receiving device on a vehicle. Based on the other party involved in the communication, it may be further divided into V2V service, V2I service, and V2P service.

A V2X-enabled UE is a UE that supports the V2X service. A V2V Service is a type of V2X service, where both parties involved in communication are vehicles. A V2V communication range is a direct communication range between two vehicles involved in the V2V service.

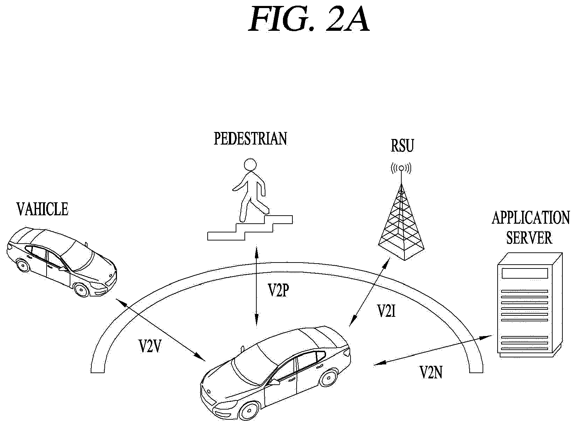

V2X applications, referred to as vehicle-to-everything (V2X), may include the four different types, as described above, namely, (1) vehicle-to-vehicle (V2V), (2) vehicle-to-infrastructure (V2I), (3) vehicle-to-network (V2N), and (4) vehicle-to-pedestrian (V2P). FIG. 2A illustrates types of V2X applications. Referring to FIG. 2A, the four types of V2X applications may use "cooperative awareness" to provide more intelligent services for end-users.

This means that, in order to provide more intelligent information, such as cooperative collision warning or autonomous traveling, entities, such as vehicles, roadside-based facilities, application servers, and pedestrians, may collect knowledge of involved local environments (e.g., information received from nearby vehicles or sensor equipment) to process and share the corresponding knowledge.

### <NR V2X>

In 3GPP Releases 14 and 15, support of the V2V and V2X services in LTE has been introduced to extend the 3GPP platform to the automotive industry.

Requirements for support of enhanced V2X use cases are largely organized into four use case groups.
(1) Vehicles platooning enables the vehicles to dynamically form a platoon traveling together. All the vehicles in the platoon obtain information from the leading vehicle to manage this platoon. This information allows the vehicles to drive closer than normal in a coordinated manner, going in the same direction and traveling together.
(2) Extended sensors enable the exchange of raw or processed data gathered through local sensors or live video images among vehicles, road site units, devices of pedestrians and V2X application servers. The vehicle may recognize an environment much more than through detection by its sensor and may recognize a local situation as a whole in a more extensive manner. A high data transmission rate is one of primarily features of the extended sensor.
(3) Advanced driving enables semi-automatic or fully-automatic driving. The advanced driving enables each vehicle and/or each RSU to share self-recognition data obtained from a local sensor with a nearby vehicle and to synchronize and adjust a trajectory or a maneuver. Each vehicle shares its intention to drive with a nearby vehicle.
(4) Remote driving enables a remote driver or a V2X application to operate a remote vehicle for those occupants who cannot drive by themselves or remote vehicles located in dangerous environments. Cloud computing-based driving may be used in the case where fluctuation is limited and a path is predictable like public transportation. High reliability and low latency are key requirements for the remote driving.

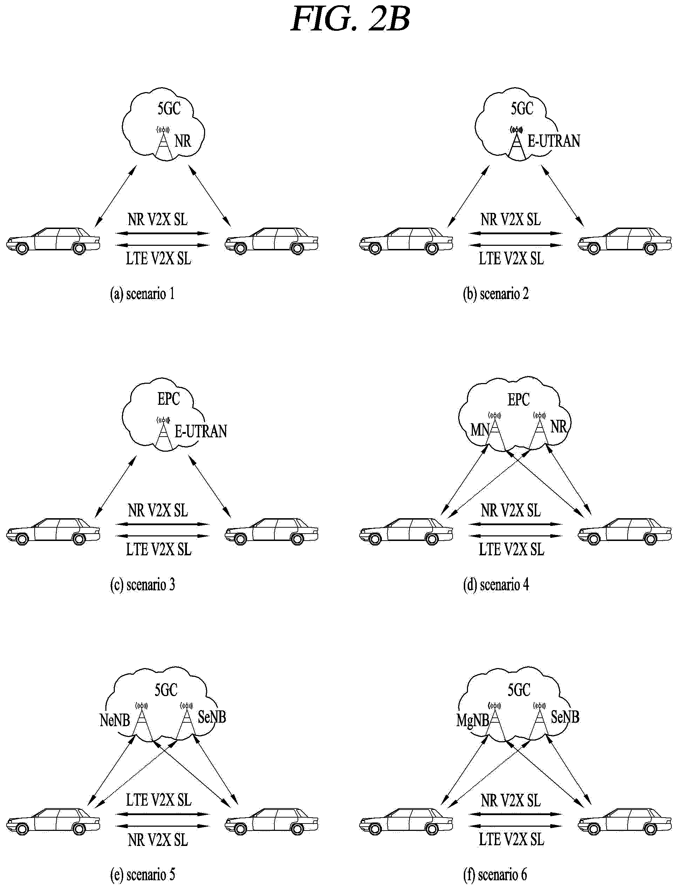

The following description may be applicable to both NR sidelink (SL) and LTE SL, and may denote NR SL when no radio access technology (RAT) is indicated. Six operational scenarios may be considered in NR V2X as follows. In this regard, FIG. 2B illustrates a standalone scenario supporting V2X SL communication and an MR-DC scenario supporting V2X SL communication.

In particular, 1) in Scenario 1, gNB provides control/configuration for V2X communication of a UE in both LTE SL and NR SL. 2) In Scenario 2, ng-eNB provides control/configuration for V2X communication of the UE in both LTE SL and NR SL. 3) In Scenario 3, eNB provides control/configuration for UE's V2X communication in both LTE SL and NR SL. On the other hand, 4) in Scenario 4, V2X communication of the UE in LTE SL and NR SL is controlled/configured by Uu while the UE is configured with Evolved-Universal Terrestrial Radio Access-New Radio Dual Connectivity (EN-DC). 5) In Scenario 5, V2X communication of the UE in LTE SL and NR SL is controlled/configured by Uu while the UE is configured in NR-E-UTRA Dual Connectivity (NE-DC). 6) In Scenario 6, V2X communication of the UE in LTE SL and NR SL is controlled/configured by Uu while the UE is configured with NG-RAN-E-UTRA UTRA Dual Connectivity (NGEN-DC).

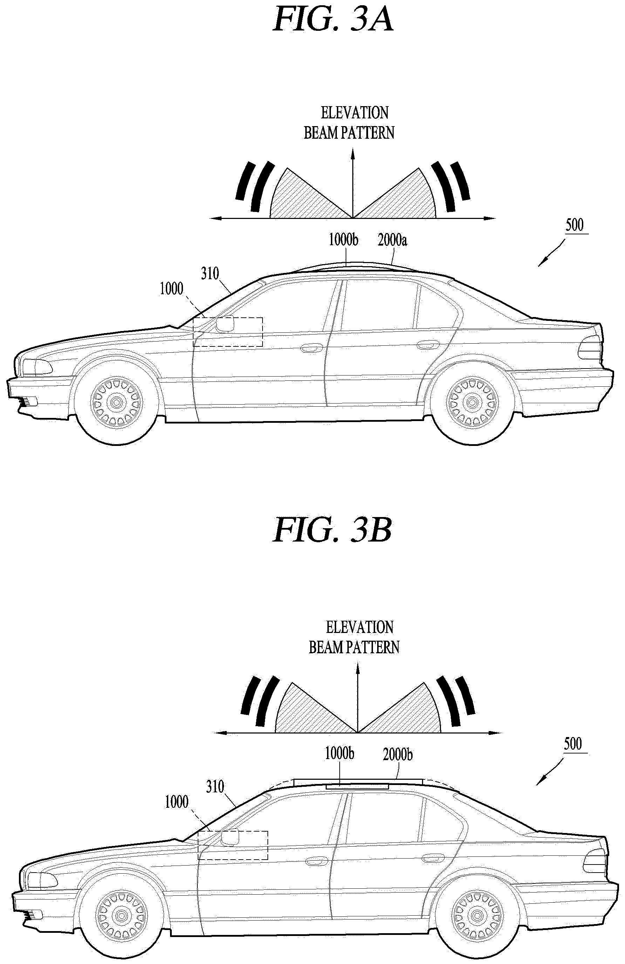

In order to support the V2X communication, as illustrated in FIGS. 2A and 2B, the vehicle may perform wireless communication with eNB and/or gNB through an antenna system. The antenna system may be configured as an internal antenna system as illustrated in FIGS. 1A and 1B. The antenna system may alternatively be implemented as an external antenna system and/or an internal antenna system as illustrated in FIGS. 3A to 3C.

FIGS. 3A to 3C are views illustrating an example of a structure for mounting an antenna system on a vehicle, which includes the antenna system mounted on the vehicle. In this regard, FIGS. 3A to 3C illustrate a configuration capable of performing wireless communication through a transparent antenna disposed on the front window 310 of the vehicle. An antenna system 1000 including a transparent antenna may be disposed on a front window of a vehicle and inside the vehicle. Wireless communication may also be performed through a transparent antenna disposed on side glass of the vehicle, in addition to the front window.

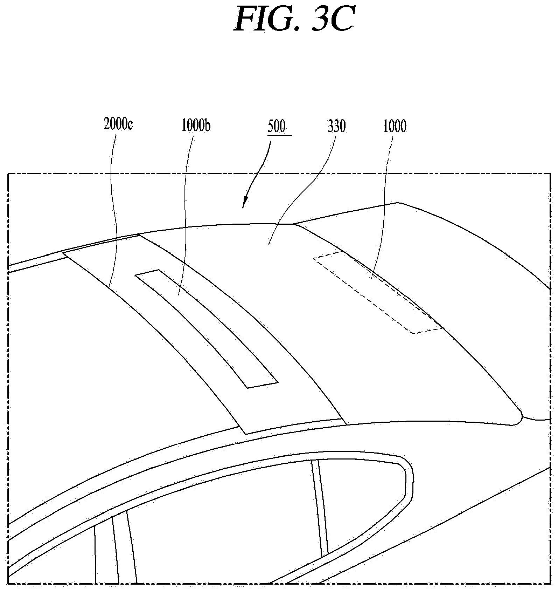

The antenna system for the vehicle that includes the transparent antenna may be combined with other antennas. Referring to FIGS. 3A to 3C, in addition to the antenna system 1000 implemented as the transparent antenna, a separate antenna system 1000b may be further configured. FIGS. 3A and 3B illustrate a structure in which the antenna system 1000b, in addition to the antenna system 1000, is mounted on or in a roof of the vehicle. On the other hand, FIG. 3C illustrates a structure in which the separate antenna system 1000b, in addition to the antenna system 1000, is mounted in a roof of the vehicle or a roof frame of a rear mirror of the vehicle.

Referring to FIGS. 3A to 3C, to improve the appearance of the vehicle and to maintain a telematics performance at the time of collision, an existing shark fin antenna may be replaced with a flat antenna of a non-protruding shape. In addition, the present disclosure proposes an integrated antenna of an LTE antenna and a 5G antenna considering fifth generation (5G) communication while providing the existing mobile communication service (e.g., LTE).

Referring to FIG. 3A, the antenna system 1000 implemented as the transparent antenna may be disposed on the front window 310 of the vehicle or inside the vehicle. The second antenna system 1000b corresponding to an external antenna may be disposed on the roof of the vehicle. In FIG. 3A, a radome 2000a may cover the second antenna system 1000b to protect the second antenna system 1000b from an external environment and external impacts while the vehicle travels. The radome 2000a may be made of a dielectric material through which radio signals are transmitted/received between the second antenna system 1000b and a base station.

Referring to FIG. 3B, the antenna system 1000 implemented as the transparent may be disposed on the front window 310 of the vehicle and inside the vehicle. In some embodiments, the second antenna system 1000b corresponding to the external antenna may be disposed within a roof structure of the vehicle and at least part of the roof structure may be made of a non-metallic material. In this instance, the roof structure 2000b of the vehicle except for the at least part made of the non-metallic material may be made of a dielectric material through which radio signals are transmitted/received between the antenna system 1000b and the base station.

Referring to FIG. 3C, the antenna system 1000 implemented as the transparent may be disposed on a rear window 330 of the vehicle and inside the vehicle. The second antenna system 1000b corresponding to the external antenna may be disposed within a roof frame 2000c of the vehicle, and at least part of the roof frame 2000c may be made of a non-metallic material. In this instance, the roof frame 2000c of the vehicle 500 except for the at least part made of the non-metallic material may be made of a dielectric material through which radio signals are transmitted/received between the second antenna system 1000b and the base station.

Referring to FIGS. 3A to 3C, antennas provided in the antenna system 1000 mounted on the vehicle may form a beam pattern in a direction perpendicular to the front window 310 or the rear window 330. Antennas provided in the second antenna system 1000 mounted on the vehicle may further define a beam coverage by a predetermined angle in a horizontal region with respect to the vehicle body.

Meanwhile, the vehicle 500 may include only the antenna unit (i.e., the internal antenna system) 1000 corresponding to the internal antenna without the antenna system 1000b corresponding to the external antenna.

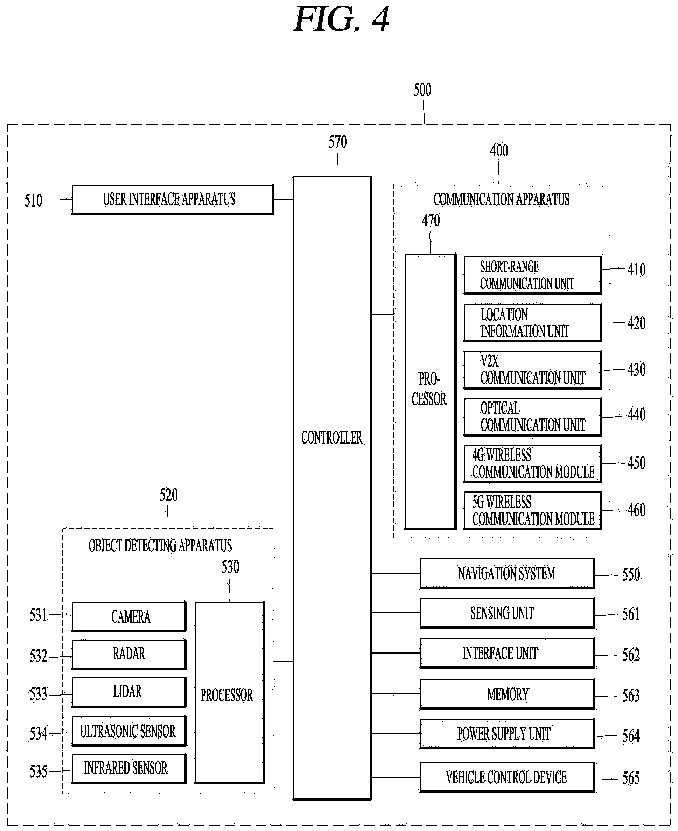

Meanwhile, FIG. 4 is a block diagram illustrating a vehicle and an antenna system mounted on the vehicle in accordance with an implementation.

The vehicle 500 may be an autonomous (driving) vehicle. The vehicle 500 may be switched into an autonomous driving mode or a manual mode (a pseudo driving mode) based on a user input. For example, the vehicle 500 may be switched from the manual mode into the autonomous mode or from the autonomous mode into the manual mode based on a user input received through a user interface device 510.

In relation to the manual mode and the autonomous driving mode, operations such as object detection, wireless communication, navigation, and operations of vehicle sensors and interfaces may be performed by the telematics control unit mounted on the vehicle 500. Specifically, the telematics control unit mounted on the vehicle 500 may perform the operations in cooperation with an antenna module 300, an object detection apparatus 520, and other interfaces. In some examples, a communication device 400 may be disposed in the telematics control unit separately from the antenna system 300 or may be disposed in the antenna system 300.

The vehicle 500 may be switched into the autonomous mode or the manual mode based on driving environment information. The driving environment information may be generated based on object information provided by the object detection apparatus 520. For example, the vehicle 500 may be switched from the manual mode into the autonomous driving mode or from the autonomous driving mode into the manual mode based on driving environment information generated in the object detection apparatus 520.

For example, the vehicle 500 may be switched from the manual mode into the autonomous driving mode or from the autonomous driving mode into the manual mode based on driving environment information received through the communication device 400. The vehicle 500 may be switched from the manual mode into the autonomous mode or from the autonomous module into the manual mode based on information, data, or signal provided from an external device.

When the vehicle 500 is driven in the autonomous driving mode, the autonomous vehicle 500 may be driven based on an operation system. For example, the autonomous vehicle 500 may travel based on information, data, or signal generated in a driving system, a parking-lot departure system, or a parking-lot entrance system. When the vehicle 500 runs in the manual mode, the autonomous vehicle 500 may receive user input for driving through a driving operation apparatus. The vehicle 500 may travel based on the user input received through a driving operation apparatus.

The vehicle 500 may include a user interface device 510, an object detection device 520, a navigation system 550, and a communication device 400. The vehicle may further include a sensing unit 561, an interface unit 562, a memory 563, a power supply unit 564, and a vehicle control device 565 in addition to the aforementioned apparatuses and devices. According to embodiments the vehicle 500 may include more components in addition to components described herein or may not include some of those components described herein.

The user interface device 510 may be a device for communication between the vehicle 500 and a user. The user interface device 510 may receive user input and provide information generated in the vehicle 500 to the user. The vehicle 500 may implement user interfaces (Uls) or user experiences (UXs) through the user interface device 510.

The object detection device 520 may be a device for detecting an object located at outside of the vehicle 500. The object may be a variety of things associated with operations of the vehicle 500. In some examples, objects may be classified into moving objects and fixed (stationary) objects. For example, the moving objects may include other vehicles and pedestrians. The fixed objects may conceptually include, for example, traffic signals, roads, and structures. The object detection device 520 may include a camera 521, a radar 522, a LiDAR 523, an ultrasonic sensor 524, an infrared sensor 525, and a processor 530. According to an embodiment, the object detection device 520 may further include other components in addition to the components described, or may not include some of the components described.

The processor 530 may control an overall operation of each unit of the object detection device 520. The processor 530 may detect an object based on an acquired image, and track the object. The processor 530 may execute operations, such as computing a distance to the object, computing a relative speed to the object and the like, through an image processing algorithm.

According to an embodiment, the object detection device 520 may include a plurality of processors 530 or may not include any processor 530. For example, each of the camera 521, the radar 522, the LiDAR 523, the ultrasonic sensor 524, and the infrared sensor 525 may include the processor individually.

When the processor 530 is not included in the object detection device 520, the object detection device 520 may operate according to the control of a processor of an apparatus within the vehicle 500 or a controller 570.

The navigation system 550 may provide location information related to the vehicle based on information obtained through the communication device 400, in particular, a location information unit 420. Also, the navigation system 550 may provide a path (or route) guidance service to a destination based on current location information related to the vehicle. In addition, the navigation system 550 may provide guidance information related to the surrounding locations of the vehicle based on information obtained through the object detection device 520 and/or a V2X communication unit 430. In some examples, guidance information, autonomous driving service, etc. may be provided based on V2V, V2I, and V2X information obtained through a wireless communication unit 460 which operates together with the antenna system 1000.

The communication device 400 may be a device3 for performing communication with an external device. Here, the external device may be another vehicle, a mobile terminal, or a server. The communication device 400 may perform the communication by including at least one of a transmitting antenna, a receiving antenna, a radio frequency (RF) circuit, and an RF device for implementing various communication protocols. The communication device 400 may include a short-range communication unit 410, a location information unit 420, a V2X communication unit 430, an optical communication unit 440, a broadcast transceiver 450, and a processor 470. According to an embodiment, the communication device 400 may further include other components in addition to the components described, or may not include some of the components described.

The short-range communication unit 410 is a unit for facilitating short-range communications. The short-range communication unit 410 may construct short-range wireless area networks to perform short-range communication between the vehicle 500 and at least one external device. The location information unit 420 may be a unit for acquiring location information related to the vehicle 500. For example, the location information unit 420 may include a global positioning system (GPS) module or a differential global positioning system (DGPS) module.

The V2X communication unit 430 may be a unit for performing wireless communications with a server (vehicle to infrastructure; V2I), another vehicle (vehicle to vehicle; V2V), or a pedestrian (vehicle to pedestrian; V2P). The V2X communication unit 430 may include an RF circuit in which protocols for communication with an infrastructure (V2I), communication between vehicles (V2V), and communication with a pedestrian (V2P) are executable. The optical communication unit 440 may be a unit for performing communication with an external device through the medium of light. The optical communication unit 440 may include an optical transmission part for converting an electric signal into an optical signal and transmitting the optical signal to the outside, and an optical reception part for converting the received optical signal into the electric signal. According to an embodiment, the optical transmission part may be formed integrally with lamps provided on the vehicle 500.

A wireless communication unit 460 may be a unit that performs wireless communication with one or more communication systems through one or more antenna systems. The wireless communication unit 460 may transmit and/or receive a signal to and/or from a device in a first communication system through a first antenna system. In addition, the wireless communication unit 460 may transmit and/or receive a signal to and/or from a device in a second communication system through a second antenna system. For example, the first communication system and the second communication system may be an LTE communication system and a 5G communication system, respectively. However, the first communication system and the second communication system may not be limited thereto, and may be changed according to applications.

In some examples, the antenna module 300 disposed in the vehicle 500 may include a wireless communication unit. In this regard, the vehicle 500 may be an electric vehicle (EV) or a vehicle that is accessible to a communication system independently of an external electronic device. In this regard, the communication device 400 may include at least one of the short-range communication unit 410, the location information unit 420, the V2X communication unit 430, the optical communication unit 440, a 4G wireless communication module 450, and a 5G wireless communication module 460.

The 4G wireless communication module 450 may perform transmission and reception of 4G signals with a 4G base station through a 4G mobile communication network. In this instance, the 4G wireless communication module 450 may transmit at least one 4G transmission signal to the 4G base station. In addition, the 4G wireless communication module 450 may receive at least one 4G reception signal from the 4G base station. In this regard, uplink (UL) Multi-input/Multi-output (MIMO) may be performed by a plurality of 4G transmission signals transmitted to the 4G base station. In addition, downlink (DL) MIMO may be performed by a plurality of 4G reception signals received from the 4G base station.

The 5G wireless communication module 460 may perform transmission and reception of 5G signals with a 5G base station through a 5G mobile communication network. Here, the 4G base station and the 5G base station may have a non-stand-alone (NSA) architecture. The 4G base station and the 5G base station may be disposed in the non-stand-alone (NSA) architecture. Alternatively, the 5G base station may be disposed in a stand-alone (SA) architecture at a separate location from the 4G base station. The 5G wireless communication module 460 may perform transmission and reception of 5G signals with a 5G base station through a 5G mobile communication network. In this case, the 5G wireless communication module 460 may transmit at least one 5G transmission signal to the 5G base station. In addition, the 5G wireless communication module 460 may receive at least one 5G reception signal from the 5G base station. In this instance, a 5G frequency band that is the same as a 4G frequency band may be used, and this may be referred to as LTE re-farming. In some examples, a Sub6 frequency band, which is a range of 6 GHz or less, may be used as the 5G frequency band. In contrast, a millimeter-wave (mmWave) band may be used as the 5G frequency band to perform wideband high-speed communication. When the mmWave band is used, the electronic device may perform beamforming for coverage expansion of an area where communication with a base station is possible.

Regardless of the 5G frequency band, in the 5G communication system, MIMO may be supported to be performed a plurality of times, to improve a transmission rate. In this instance, UL MIMO may be performed by a plurality of 5G transmission signals that are transmitted to a 5G base station. In addition, DL MIMO may be performed by a plurality of 5G reception signals received from the 5G base station.

In some examples, a state of dual connectivity (DC) with both the 4G base station and the 5G base station may be attained through the 4G wireless communication module 450 and the 5G wireless communication module 460. As such, the dual connectivity with the 4G base station and the 5G base station may be referred to as EUTRAN NR DC (EN-DC). In some examples, when the 4G base station and 5G base station are disposed in a co-located structure, throughput improvement may be achieved by inter-carrier aggregation (inter-CA). Accordingly, when the 4G base station and the 5G base station are disposed in the EN-DC state, the 4G reception signal and the 5G reception signal may be simultaneously received through the 4G wireless communication module 450 and the 5G wireless communication module 460. Short-range communication between electronic devices (e.g., vehicles) may be performed using the 4G wireless communication module 450 and the 5G wireless communication module 460. In one embodiment, after resources are allocated, vehicles may perform wireless communication in a V2V manner without a base station.

Meanwhile, for transmission rate improvement and communication system convergence, carrier aggregation (CA) may be carried out using at least one of the 4G wireless communication module 450 and the 5G wireless communication module 460 and a WiFi communication module 113. In this regard, 4G + WiFi carrier aggregation (CA) may be performed using the 4G wireless communication module 450 and the WiFi communication module 113. Or, 5G + WiFi CA may be performed using the 5G wireless communication module 460 and the WiFi communication module.

In some examples, the communication device 400 may implement a display device for a vehicle together with the user interface device 510. In this instance, the display device for the vehicle may be referred to as a telematics apparatus or an audio video navigation (AVN) apparatus.

The processor 470 of the communication device 400 may correspond to a modem. In this regard, an RFIC and the modem may be referred to as a first controller (or a first processor) and a second controller (a second processor), respectively. Meanwhile, the RFIC and the modem may be implemented as physically separate circuits. Alternatively, the RFIC and the modem may be logically or functionally separated from each other on one physical circuit. The modem may perform control and signal processing for signal transmission and reception through different communication systems using the RFID. The modem 1400 may acquire control information from a 4G base station and/or a 5G base station. Here, the control information may be received through a physical downlink control channel (PDCCH), but is not limited thereto.

The modem may control the RFIC 1250 to transmit and/or receive signals through the first communication system and/or the second communication system for a specific time interval and from frequency resources. Accordingly, the vehicle may be allocated resources or maintain a connected state through the eNB or gNB. In addition, the vehicle may perform at least one of V2V communication, V2I communication, and V2P communication with other entities using the allocated resources.

Meanwhile, referring to FIGS. 1A to 4, the antenna module mounted in the vehicle may be placed inside the vehicle, on the roof of the vehicle, inside the roof, or inside the roof frame. In this regard, the antenna system disclosed herein may be configured to operate in the low band (LB), the mid band (MB), and a high band (HB) of a 4G LTE system and a Sub6 band of a 5G new radio (NR) system. In addition, the antenna system disclosed herein may be configured to operate in a 2.4 GHz band and a 5 GHz band for Wi-Fi communication services.

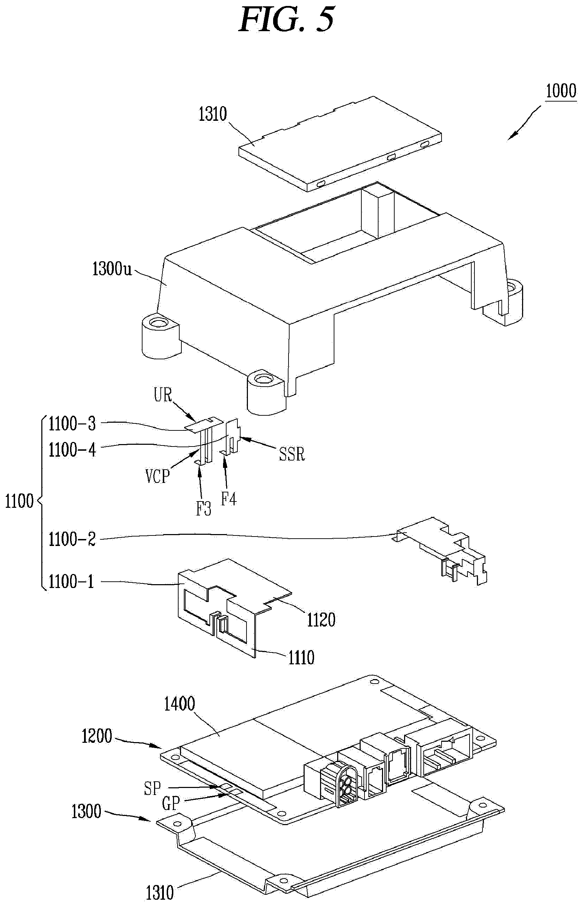

Hereinafter, a structure of a vehicle antenna structure mounted in a vehicle according to the present disclosure is described. In relation to this, FIG. 5 is an exploded perspective view of the vehicle antenna module according to the present disclosure. Referring to FIG. 5, an antenna element 1100 may be implemented as a separate metal member or metal pattern, and may be connected to a printed circuit board (PCB) 1200 through a feeding structure 1130 and a short circuit structure 1140. To do so, the antenna element 1100 may be configured as a metal pattern on a separate PCB.

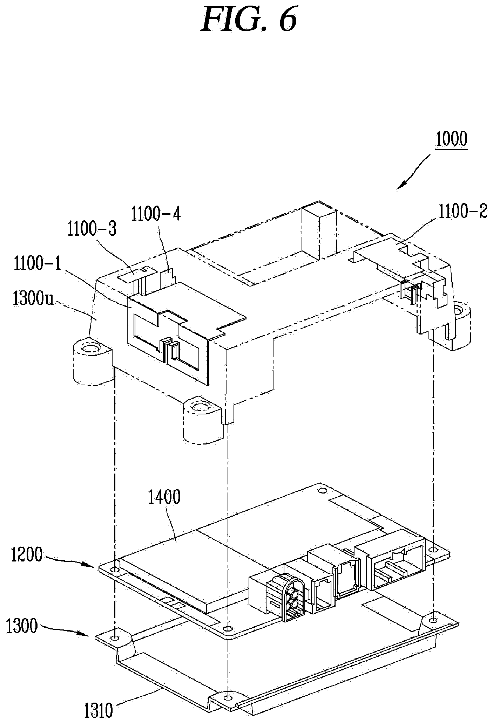

Meanwhile, FIG. 6 illustrates a structure in which antenna elements are disposed on an upper cover of the vehicle antenna module of FIG. 5. Referring to FIG. 6, the antenna element 1100 may be disposed on an upper cover 1300u in a form of a metal pattern without a separate PCB or a support structure.

Referring to FIGS. 5 and 6, the antenna module 1000 for the vehicle may be configured to include the antenna element 1100 and the PCB 1200. The vehicle antenna module 1000 may be configured to include a lower cover 1300 and the upper cover 1300u.

The PCB 1200 may be configured to have electronic components placed thereon. Since the antenna element 1100 is arranged on the PCB 1200, the PCB 1200 may also be referred to as an antenna PCB. In relation to this, the PCB 1200 may be operatively combined with a telematics control unit (TCU). The PCB 1200 may be implemented on a same PCB as the telematics control unit, or may be combined with a telematics control unit implemented on a separate PCB to be disposed on a same plane via a fastening element such as a connector. As another example, a separate PCB implemented as a telematics control unit may be placed in a lower region or an upper region of the PCB 1200.

The antenna element 1100 may be configured to be connected to a metal pattern on the PCB 1200 to radiate a wireless signal. The lower cover 1300 may be placed below the PCB 1200 and configured as a metal plate. A heat sink structure may be disposed in a partial region of the lower cover 1300 to absorb or release heat generated from the electronic components placed on the PCB 1200. The upper cover 1300u may be configured to be combined with the lower cover 1300 to accommodate the antenna element 1100 and the PCB 1200 therein.

The antenna element 1100 may be configured to include a first antenna 1100-1 and a second antenna 1100-2. In relation to this, the number of antenna modules 1100 is not limited to two, and may be variously changed according applications. The first antenna 1100-1 may be placed to be adjacent to one side of an accommodation space of a backup battery 1310 placed on the upper cover 1300u. The backup battery 1310 may be placed on the upper cover 1300u and configured to supply power to inside of the antenna module. The second antenna 1100-2 may be placed in a lower region of the accommodation space of the backup battery 1310. The second antenna 1100-2 may be disposed to be offset toward a lower region further than the first antenna 1100-1.

Accordingly, the first antenna 1100-1 and the second antenna 1100-2 may be implemented to have an optimal arrangement structure within a limited space of an antenna area. In this regard, the first antenna 1100-1 and the second antenna 1100-2 are disposed to be offset in one axial direction. Accordingly, isolation between the first antenna 1100-1 and the second antenna 1100-2 may be improved depending on an offset arrangement structure.

Each element of the antenna element 1100 may include a plurality of conductive parts. Accordingly, as each of the conductive parts or a combination thereof resonate in different bands, the antenna element 1100 may perform broadband operation. In this regard, the antenna element 1100 may be configured to include a first conductive part 1110 and a second conductive part 1120. In relation to this, the first conductive part 1110 and the second conductive part 1120 may be referred to as a first antenna structure (or a first conductive pattern) and a second antenna structure (or a second conductive pattern), respectively.

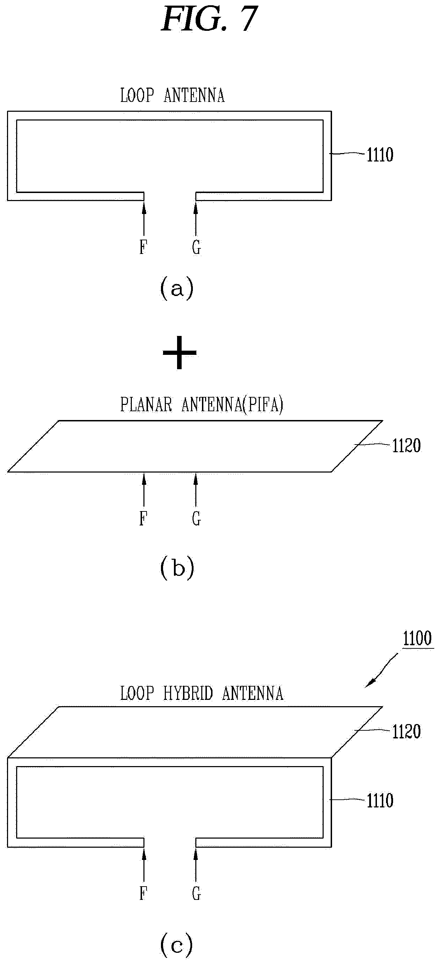

In this regard, FIG. 7 illustrates an equivalent antenna structure related to a broadband operation of an antenna element according to the present disclosure. Referring to FIG. 5 to (a) of FIG. 7, the first conductive part 1110 having a shape of a loop antenna may be arranged in a vertical direction. The first conductive part 1110 may be configured as a first metal pattern having a shape of a loop antenna. Both ends of the first metal pattern of the first conductive part 1110 may be connected to a feeding portion F and a short circuit portion G, respectively.

Referring to FIG. 5, FIG. 6 and (b) of FIG. 7, the second conductive part 1120 having a shape of a patch antenna may be arranged in a horizontal direction. The second conductive part 1120 may be configured as a second metal pattern having a shape of a patch antenna. A first point and a second point of the second metal pattern of the second conductive part 1120 may be connected to the feed portion F and the short circuit portion G, respectively. Accordingly, the second conductive part 1120 having a shape of a patch antenna may be connected to the short-circuit portion G to be configured as a planar inverted-F antenna (PIFA).

In a first band, i.e., a low band (LB) among 4G/5G communication bands, the second conductive part 1120 having a form of an upper patch may operate as a main radiator. On the other hand, the first conductive part 1110 in a form of a loop radiator may operate as a main radiator in a second band, i.e., the mid band (MB) and the high band (HB) among 4G/5G communication bands.

Accordingly, referring to FIG. 5 to (c) of FIG. 7, the antenna element 1100 may be configured by combining the first conductive part 1110 having a loop shape with the second conductive part 1120 having a patch shape. Thus, as the antenna element 1100 of the vehicle antenna module according to the present disclosure operate in multiple modes, the antenna element 1100 may operate as a broadband radiator. Accordingly, the antenna element 1100 of the vehicle antenna module may be configured as a loop hybrid antenna structure in which a loop antenna is combined with a flat surface type antenna.

Meanwhile, the antenna element 1100 of the vehicle antenna module according to the present disclosure may perform 2x2 multiple-input multiple-output (MIMO) operation as shown in FIGS. 5 and 6. The antenna element 1100 may be configured to include a Wi-Fi/global navigation satellite system (GNSS) antenna as shown in FIGS. 5 and 6. In addition, in the vehicle antenna module in which the antenna element 1100 is disposed, a telematics module may be implemented on the PCB 1200 to constitute a TCU/antenna integrated structure.

Meanwhile, when the vehicle antenna module 1000 is implemented as an internal antenna inside the vehicle, a configuration may be selectively expanded through a separate external antenna to perform 4x4 MIMO operation. In addition, when the vehicle antenna module 1000 is implemented as an external antenna outside the vehicle, a configuration may be selectively expanded through a separate internal antenna to perform 4x4 MIMO operation.

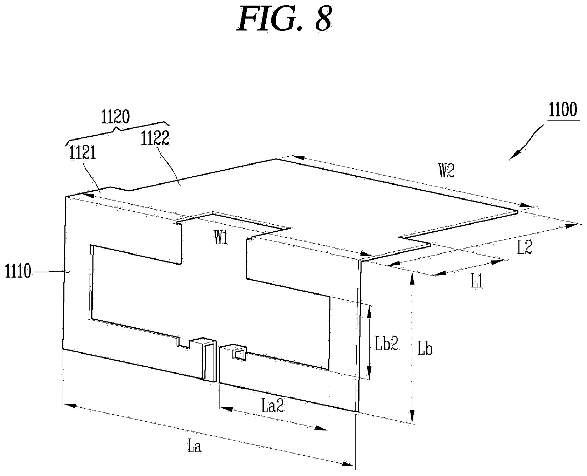

Meanwhile, FIG. 8 is a side perspective view of an antenna element according to the present disclosure.

Referring to FIGS. 5 to 8, the first conductive part 1110 may be disposed to be perpendicular to the PCB 1200 within a predetermined angle range. The first conductive part 1110 may be configured as a first metal pattern. The first metal pattern of the first conductive part 1110 may be disposed to have a loop shape. A lower end of the first metal pattern of the first conductive part 1110 may be configured to be in contact with or spaced apart from a metal pattern of the PCB 1200.

The second conductive part 1120 may have the second metal pattern disposed at an upper end of the first metal pattern to be in parallel with the PCB 1200.

Meanwhile, the antenna element 1100 disclosed herein may be configured to radiate a first signal through the first conductive part 1110 and the second conductive part 1120 in the first band. Additionally, the antenna element 1100 may be configured to radiate a second signal through the first conductive part 1110 in a second band different from the first band. As one example, the second band may be defined as a band higher than the first band.

In relation to this, the first band may be defined as the low band (LB) of a 4G/5G communication system. Additionally, the second band may be defined as the mid band (MB) and the high band (HB) of the 4G/5G communication system, but is not limited thereto.

In detail, a length La of a lower pattern of a first metal line of the first conductive part 1110 may be determined so that the antenna element 1100 operates in the low band (LB). Meanwhile, a sum of the length La of the lower pattern and a side length Lb of the first metal line may be determined so that the antenna element 1100 operates in the mid band (MB).

In addition, a length La2 of one side of the lower pattern of the first metal line may be determined so that the antenna element 1100 operates in a 5G Sub6 band. A distance Lb2 between the lower pattern and an upper pattern of the first metal line may be determined so that the antenna element 1100 operates in the high band (HB).

The second conductive part 1120 may be configured to have an upper patch structure. The second conductive part 1120 may include a plurality of metal regions. As one example, the second conductive part 1120 may be configured to include a first metal region 1121 and a second metal region 1122.

The first metal region 1121 may be disposed to be connected to the first metal line of the first conductive part 1110. The first metal region 1121 may be configured as a metal pattern having a first width W1 and a first length L1. Meanwhile, the second metal region 1122 may be configured to have a width different from that of the first metal region 1121. The second metal region 1122 may be configured as a metal pattern connected to the first metal region 1121. The second metal region 1122 may be configured to have a second width W2 smaller than the first width W1 of the first metal region 1121.

A total length of the first metal region 1121 and the second metal region 1122 may be defined as a second length L2. The first length L1 of the first metal region 1121 may be determined so that the antenna element 1100 operates in the mid band (MB). The second length L2, i.e., the total length of the first metal region 1121 and the second metal region 1122 may be determined so that the antenna element 1100 operates in the low band (LB).

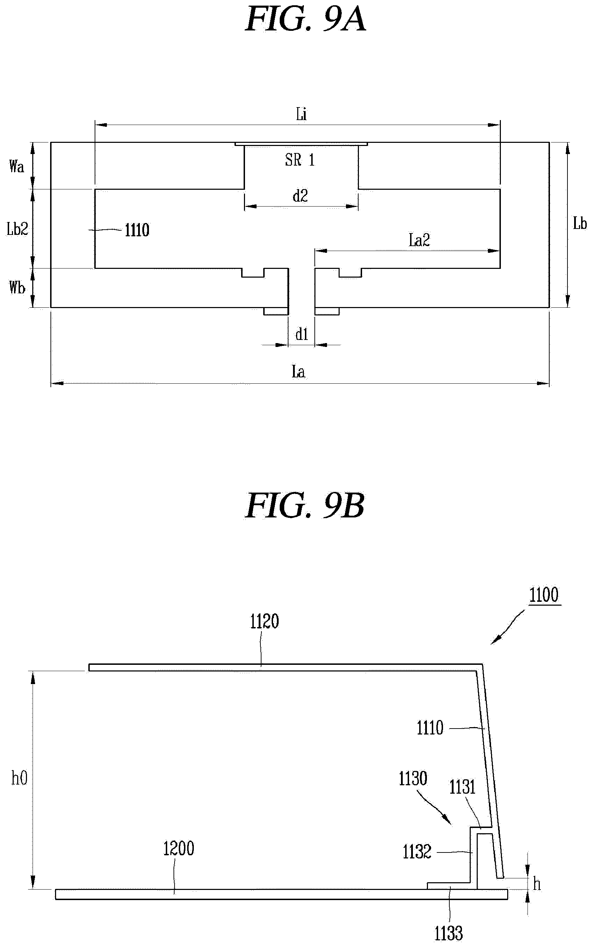

Meanwhile, a conductive part according to the present disclosure may be electrically connected to a PCB of an antenna module through a feeding structure and a short-circuit structure. In relation to this, FIGS. 9A to 10B illustrate a first side view, a second side view, a front view, and a third side view of the antenna element of FIG. 8, respectively.

FIG. 9A is the first side view of the antenna element 1100 of FIG. 8 as viewed from a first side surface on which the first conductive part 1110 is disposed. Referring to FIGS. 5 to 9A, the length La of the lower pattern of the first metal line of the first conductive part 1110 may be determined so that the antenna element 1100 operates in the low band (LB). Meanwhile, a sum of the length La of the lower pattern and the side length Lb of the first metal line may be determined so that the antenna element 1100 operates in the mid band (MB). In this regard, the side length Lb of the first metal line may be determined as a sum of the distance Lb2 between the lower pattern and the upper pattern of the first metal line and widths Wa+Wb of the first metal line.

In addition, the length La2 of one side of the lower pattern of the first metal line may be determined so that the antenna element 1100 operates in the 5G Sub6 band. The distance Lb2 between the lower pattern and the upper pattern of the first metal line may be determined so that the antenna element 1100 operates in the high band (HB). In relation to this, the length La2 of one side of the lower pattern of the first metal line may be determined as half of a difference between an inner length Li of the first metal line and a distance d1 of a gap in the lower pattern of the first metal line.

FIG. 9B is the second side view of the antenna element 1100 of FIG. 8, as viewed from a second side surface adjacent to the first side surface on which the first conductive part 1110 is disposed. Referring to FIGS. 5 to 9B, the first conductive part 1110 may be disposed to be perpendicular or bent at an angle from a right angle to a predetermined angle relative to the second conductive part 1120. The first conductive part 1110 may be placed to be apart from the PCB 1200 by a predetermined height h. Accordingly, the feeding structure 1130 other than the first metal line of the first conductive part 1110 may be disposed to be in contact with the PCB 1200. A height from the PCB 1200 to the second conductive part 1120, i.e., a total height h0 of the antenna element 1100 may be determined.

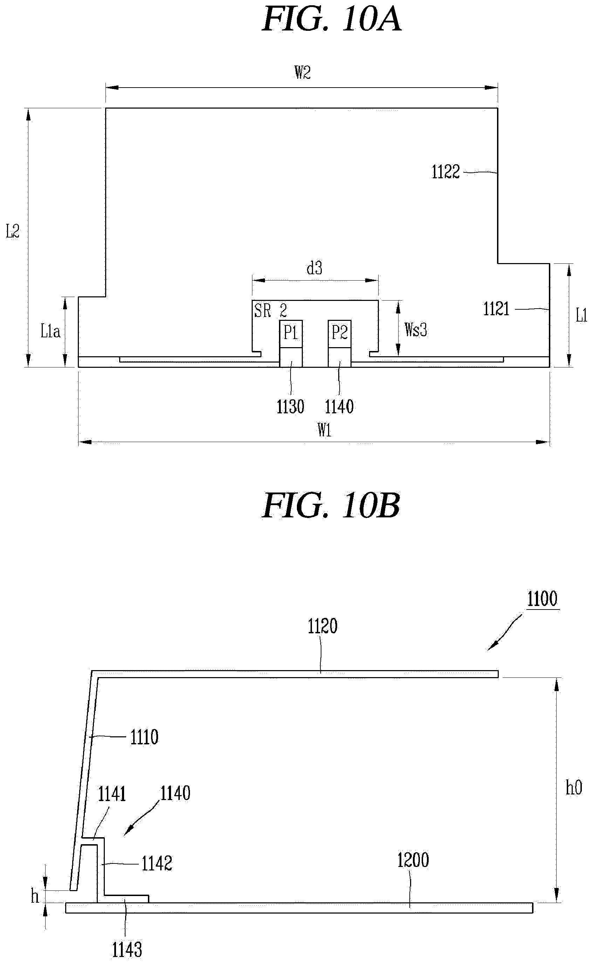

Referring to FIG. 10A, a front view of the antenna element 1100 of FIG. 8 is shown. Referring to FIGS. 5 to 10A, the antenna element 1100 may further include the feeding structure 1130 and the short circuit structure 1140. The feeding structure 1130 and the short circuit structure 1140 may be disposed at one end and another end of the lower pattern of the first metal line, respectively, but are not limited thereto. In relation to this, positions in which the feeding structure 1130 and the short-circuit structure 1140 are disposed are not limited to a first separation point P1 and a second separation point P2, respectively. As another example, positions in which the feeding structure 1130 and the short circuit structure 1140 are disposed may be determined as the second separation point P2 and the first separation point P1, respectively. In addition, points at which the first separation point P1 and the second separation point P2 are disposed may be configured in an asymmetrical structure with reference to a center line of the lower pattern of the first metal line.

The feeding structure 1130 may be configured to extend from an upper end of the first separation point P1 of the lower pattern of the first metal pattern of the first conductive part 1110 to be connected to a signal pattern of the PCB 1200. In relation to this, the feeding structure 1130 may be configured to include a first feed pattern 1131 to a third feed pattern 1133. The first feed pattern 1131 may be disposed to extend from an upper end of the first separation point P1 of the lower pattern of the first metal pattern of the first conductive part 1110. The first feed pattern 1131 may be disposed in parallel with the PCB 1200.

A second feed pattern 1132 may be disposed to extend from an end of the first feed pattern 1131. The second feed pattern 1132 may be disposed to be perpendicular to the first feed pattern 1131. The third feed pattern 1133 may be disposed to extend from an end of the second feed pattern 1132. The third feed pattern 1133 may be disposed to be perpendicular to the second feed pattern 1132. The third feed pattern 1133 may be configured to be connected to a signal pattern of the PCB 1200.

FIG. 10B is the third side view of the antenna element 1100 of FIG. 8, as viewed from a third side surface adjacent to the first side surface on which the first conductive part 1110 is disposed. Referring to FIGS. 5 to 9A and 10B, the first conductive part 1110 may be disposed to be perpendicular or bent at an angle from a right angle to a predetermined angle relative to the second conductive part 1120. The first conductive part 1110 may be placed to be apart from the PCB 1200 by the predetermined height h. Accordingly, the short circuit structure 1140 other than the first metal line of the first conductive part 1110 may be disposed to be in contact with the PCB 1200.

The short circuit structure 1140 may be configured to extend from an upper end of the second separation point P2 of the lower pattern of the first metal pattern of the first conductive part 1110 to be connected to a ground pattern GP of the PCB 1200. The short circuit structure 1140 may also be disposed as a vertical connection structure corresponding to the feeding structure 1130.

In relation to this, the short circuit structure 1140 may be configured to include a first short circuit pattern 1141 to a third short circuit pattern 1143. The first short circuit pattern 1141 may be disposed to extend from an upper end of the second separation point P2 of the lower pattern of the first metal pattern of the first conductive part 1110. The first short circuit pattern 1141 may be arranged in parallel with the PCB 1200.

The second short circuit pattern 1142 may be disposed to extend from an end of the first short circuit pattern 1141. The second short circuit pattern 1142 may be disposed to be perpendicular to the first feed pattern 1141. The third short circuit pattern 1143 may be disposed to extend from an end of the second short circuit pattern 1142. The third short circuit pattern 1143 may be disposed to be perpendicular to the second short circuit pattern 1142. The third short circuit pattern 1143 may be configured to be connected to a ground pattern of the PCB 1200.

Referring to FIGS. 5 to 10B, a first slot region SR1 may be disposed in the upper pattern of the first metal pattern of the first conductive part 1110. In addition, a second slot region SR2 may be disposed in one region of the second metal pattern of the second conductive part 1120. A length L1 of one side and a length L1a of another other side of the first metal region 1121 of the second conductive part 1120 may be configured differently from each other.

The first slot region SR1 may be configured to have a second length d2 greater than a first length d1 of the gap in the lower pattern of the first metal pattern. The second slot region SR2 may be disposed in one region of the second metal pattern of the second conductive part 1120 connected to the upper pattern of the first metal pattern of the first conductive part 1110. The second slot region SR2 may be disposed to have a third length d3 equal to or greater than the second length d2 of the first slot region SR1. The second slot region SR2 may be configured to have a third width Ws3.

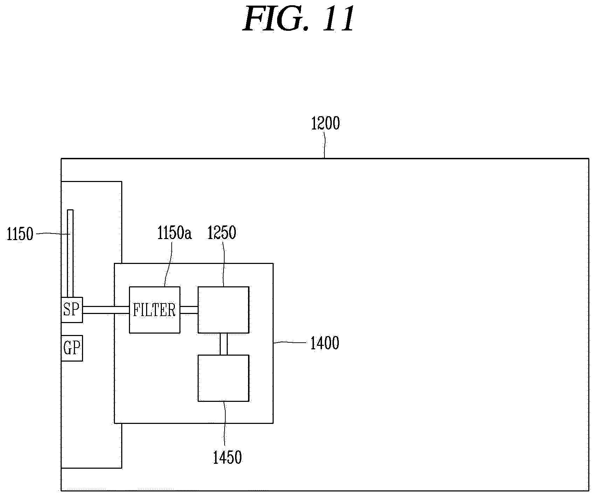

Meanwhile, the antenna element 1100 of the vehicle antenna module disclosed herein may be configured to further include a third conductive part 1150. The third conductive part 1150 may be implemented on the PCB 1200. In this regard, FIG. 11 illustrates a conductive part arranged on a PCB of the vehicle antenna module disclosed herein.

Referring to FIG. 11, the antenna element 1100 may further include the third conductive part 1150 disposed on the PCB 1200. The third conductive part 1150 may be configured to be connected to a signal pattern SP defined on the PCB 1200. The third conductive part 1150 may be configured as a dipole or monopole radiator having a metal pattern with a predetermined width and a predetermined resonant length, but is not limited thereto. As another example, the third conductive part 1150 may be configured as a loop radiator or a patch conductive part having a predetermined resonant length.

Referring to FIGS. 5 and 11, a filter structure 1150a may be placed between the signal pattern SP and the third conductive part 1150. The filter structure 1150a may be implemented as a metal pattern or a combination of electrical elements such as an inductor and a capacitor. The filter structure 1150a may be configured to branch a first signal transmitted to the first metal line of the first conductive part 1110 and a third signal transmitted to a metal pattern of the third conductive part 1150. The filter structure 1150a may be configured to separate a first signal in the first band to a third signal in a third band from a fourth signal of a fourth band higher than the third band.

A filter 1150, a transceiving circuit 1250, and a processor 1450 may be placed in the NAD 1400, but are not limited thereto. Some part of the filter 1150 and the transceiving circuit 1250 may be placed outside the NAD 1400. The transceiving circuit 1250 may transmit signals in the first band and the second band to the first conductive part 1110 and the second conductive part 1120, respectively. The transceiving circuit 1250 may transmit a signal in the third band to the third conductive part 1150.

The third conductive part 1150 may be placed on the PCB 1200 and configured to radiate a third signal in the third band higher than the second band. Accordingly, configuration may be made to radiate a third signal through the first conductive part 1110 and the third conductive part 1150 at a first frequency in the third band. In this regard, the third band may include a very high band (VHB) of the 4G/5G communication system or the Sub6 band of a 5G communication system, but is not limited thereto. Thus, configuration may be made to radiate a third signal through the third conductive part 1150 at a second frequency higher than the first frequency in the third band.

In relation to this, the first band may be defined as the low band (LB) of the 4G/5G communication system. Additionally, the second band may be defined as the mid band (MB) and the high band (HB) of the 4G/5G communication system, but is not limited thereto. As another example, the second band may be defined as the mid band (MB) of the 4G/5G communication system, and the third band may be configured as the high band (HB) of the 4G/5G communication system. Meanwhile, the fourth band may be defined as the very high band (VHB) of the 4G/5G communication system or the Sub6 band of the 5G communication system, but is not limited thereto.

Thus, the third conductive part 1150 may be placed on the PCB 1200 and configured to radiate a third signal in the fourth band higher than the third band. Accordingly, configuration may be made to radiate a third signal through the first conductive part 1110 and the third conductive part 1150 at a first frequency in the fourth band. In this regard, the fourth band may be defined as the very high band (VHB) of the 4G/5G communication system or the Sub6 band of the 5G communication system, but is not limited thereto. Thus, configuration may be made to radiate a third signal through the third conductive part 1150 at a second frequency higher than the first frequency in the fourth band.

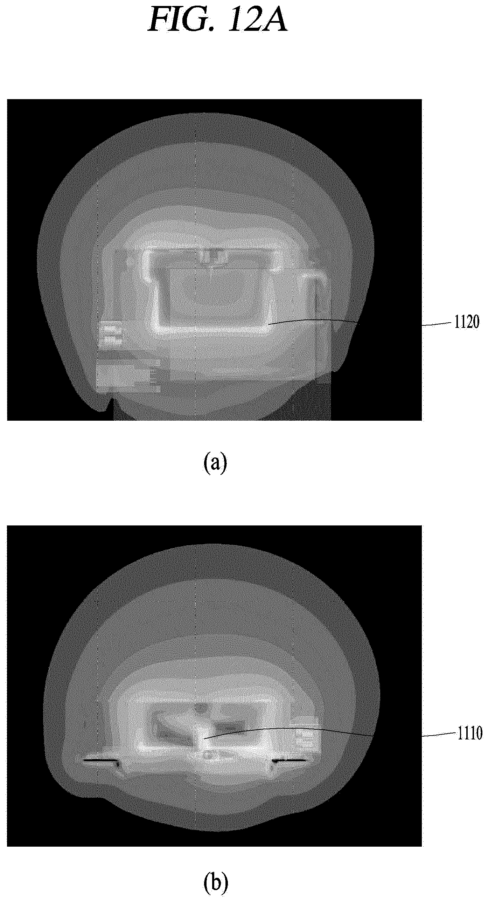

Meanwhile, the vehicle antenna module disclosed herein may perform multiple band operation for each band of the 4G/5G communication system. In this regard, FIGS. 12A to 12C illustrate electric field distributions in a region in which an antenna element is disposed and a peripheral region according to each frequency band.

FIG. 12A illustrates an electric field distribution on a front surface and a first side surface of an antenna element at a first frequency which is a low frequency in the first band. In this regard, the first band is the low band (LB) of the 4G/5G communication system, and the first frequency may be about 620 MHz, i.e., a lowest frequency in the first band, but is not limited thereto. Meanwhile, the low band (LB) of the 4G/5G communication system corresponding to the first band may be set to a frequency range of about 620 MHz to 960 MHz, but is not limited thereto.

Referring to FIG. 8, FIG. 10A, and (a) of FIG. 12A, a current value according to an electric field distribution in the second conductive part 1120 on a front surface of the antenna element 1100 is shown as being at a certain level or higher. Referring to FIG. 9A and (b) of FIG. 12A, a current value according to an electric field distribution in the first conductive part 1110 on the first side surface of the antenna element 1100 is shown as being at a certain level or lower. Thus, the antenna element 1100 may be configured to radiate a first signal through the second conductive part 1120 at the first frequency in the first band. Accordingly, the antenna element 1100 may be configured so that an upper patch operates as a main radiator at the first frequency in the first band.

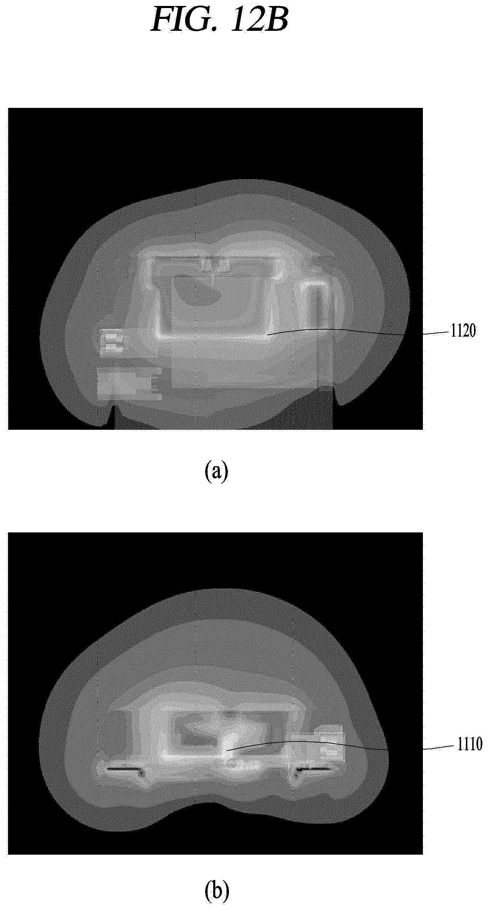

FIG. 12B illustrates an electric field distribution on a front surface and a first side surface of the antenna element at a second frequency higher than the first frequency in the first band. In this regard, the first band is the low band (LB) of the 4G/5G communication system, and the second frequency may be about 960 MHz which is a highest frequency in the first band, but is not limited thereto.

Referring to FIG. 8, FIG. 9A, and (a) of FIG. 12B, a current value according to an electric field distribution in the second conductive part 1120 on the front surface of the antenna element 1100 is shown as being at a certain level or higher. Referring to FIG. 9A and (b) of FIG. 12B, a current value according to an electric field distribution in the first conductive part 1110 of the first side surface of the antenna element 1100 is shown as being at a certain level or higher. Accordingly, the antenna element 1100 may be configured to radiate a second signal at a second frequency in the first band through the first conductive part 1110 and the second conductive part 1120. Accordingly, the antenna element 1100 may be configured so that both a loop radiator and an upper patch operate as a main radiator at the second frequency in the first band.

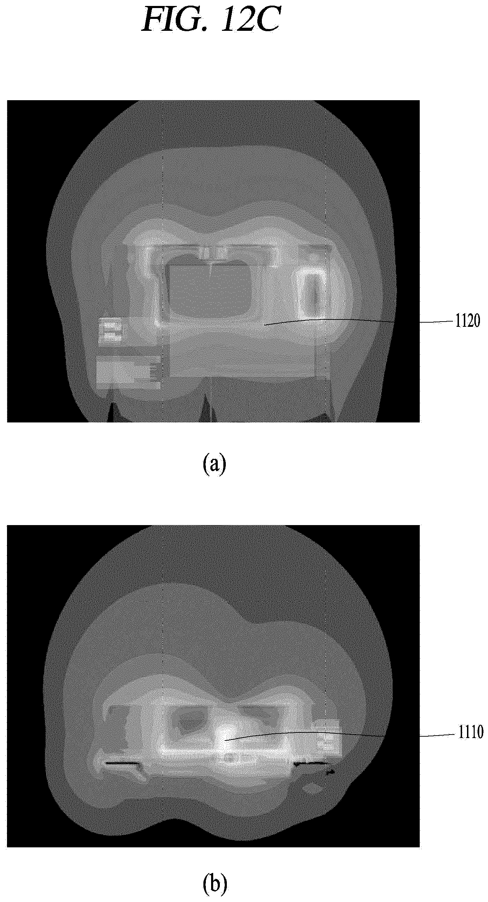

FIG. 12C illustrates an electric field distribution at the first frequency which is a low frequency in the second band higher than the first band. In relation to this, the second band may be the mid band (MB) of the 4G/5G communication system, but is not limited thereto. As one example, FIG. 12C illustrates an electric field distribution at a particular frequency of about 1700 MHz in the second band which is higher than the first band. Meanwhile, the low band (LB) of the 4G/5G communication system corresponding to the second band may be set to a frequency range of about 1710 MHz to 2170 MHz, but is not limited thereto.

Referring to FIG. 9A, and (a) of FIG. 12C, a current value according to an electric field distribution in the second conductive part 1120 on the front surface of the antenna element 1100 is shown as being at a certain level or lower Referring to FIG. 9A and (b) of FIG. 12C, a current value according to an electric field distribution in the first conductive part 1110 of the first side surface of the antenna element 1100 is shown as being at a certain level or higher. Thus, the antenna element 1100 may be configured to radiate a second signal through the second conductive part 1110 at the first frequency in the second band. Accordingly, the antenna element 1100 may be configured so that a loop radiator operates as a main radiator at the first frequency in the second band.

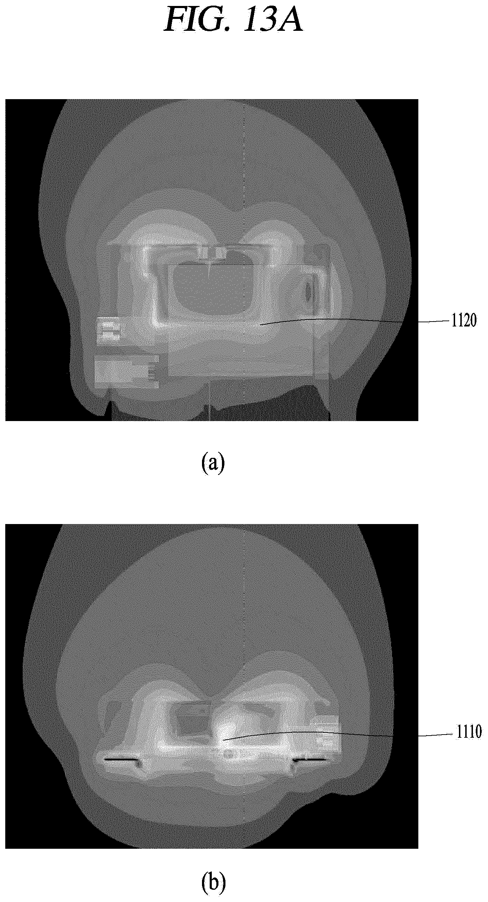

Meanwhile, the vehicle antenna module disclosed herein may perform multiple band operation for each band of the 4G/5G communication system and the 5G Sub6 band. In this regard, FIGS. 13A to 14B illustrate electric field distributions in a region in which an antenna element is arranged and a peripheral region according to each band of frequencies equal to or higher than a particular frequency.

FIG. 13A illustrates an electric field distribution on the front surface and the first side surface of the antenna element at a second frequency which a high frequency in the second band. In relation to this, the second band may be the mid band (MB) of the 4G/5G communication system, but is not limited thereto. As one example, FIG. 13A illustrates an electric field distribution at about 2100 MHz which is a particular frequency in the second band higher than the first band. As described above, the low band (LB) of the 4G/5G communication system corresponding to the second band may be set to a frequency range of about 1710 MHz to 2170 MHz, but is not limited thereto.

Referring to FIG. 9A, and (a) of FIG. 13A, a current value according to an electric field distribution in the second conductive part 1120 on the front surface of the antenna element 1100 is shown as being at a certain level or lower. Referring to FIG. 9A and (b) of FIG. 13A, a current value according to an electric field distribution in the first conductive part 1110 of the first side surface of the antenna element 1100 is shown as being at a certain level or higher. Thus, the antenna element 1100 may be configured to radiate a second signal through the first conductive part 1110 at the second frequency in the second band. Accordingly, the antenna element 1100 may be configured so that a loop radiator operates as a main radiator at the second frequency in the second band.

Referring to FIGS. 9A, 12C, and 13A, the antenna element 1100 may be configured such that a loop radiator operates as a main radiator from a lowest frequency to a highest frequency in the second band.

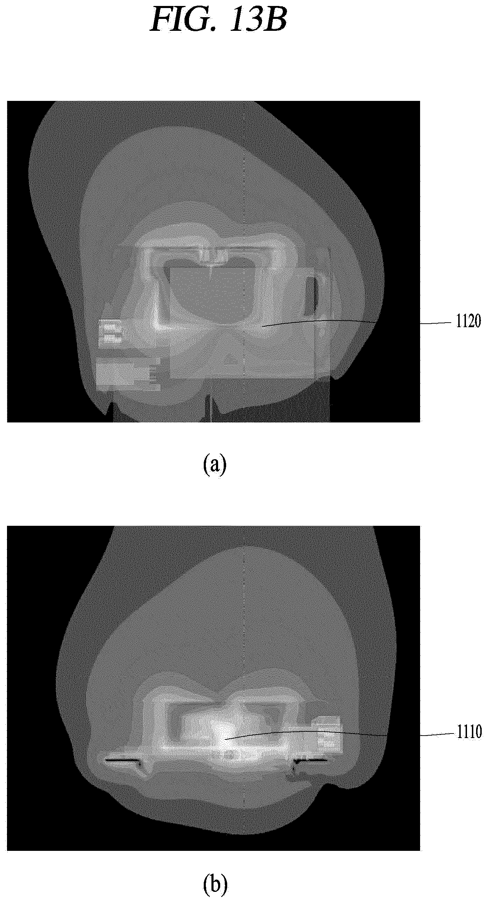

FIG. 13B illustrates an electric field distribution of the front surface and the first side surface of the antenna element at a particular frequency in the third band, i.e., an intermediate frequency. In relation to this, the third band may be the high band (MB) of the 4G/5G communication system, but is not limited thereto. As one example, FIG. 13B illustrates an electric field distribution at about 2500 MHz, i.e., a particular frequency in the third band higher than the second band. Meanwhile, the high band (HB) of the 4G/5G communication system corresponding to the third band may be set to a frequency range of about 2300 MHz to 2700 MHz, but is not limited thereto.

Referring to FIG. 9A, and (a) of FIG. 13B, a current value according to an electric field distribution in the second conductive part 1120 on the front surface of the antenna element 1100 is shown as being at a certain level or lower. Referring to FIG. 9A and (b) of FIG. 13A, a current value according to an electric field distribution in the first conductive part 1110 of the first side surface of the antenna element 1100 is shown as being at a certain level or higher. Accordingly, the antenna element 1100 may be configured to radiate a third signal through the first conductive part 1110 in the third band. Accordingly, the antenna element 1100 may be configured so that a loop radiator operates as a main radiator in the third band.

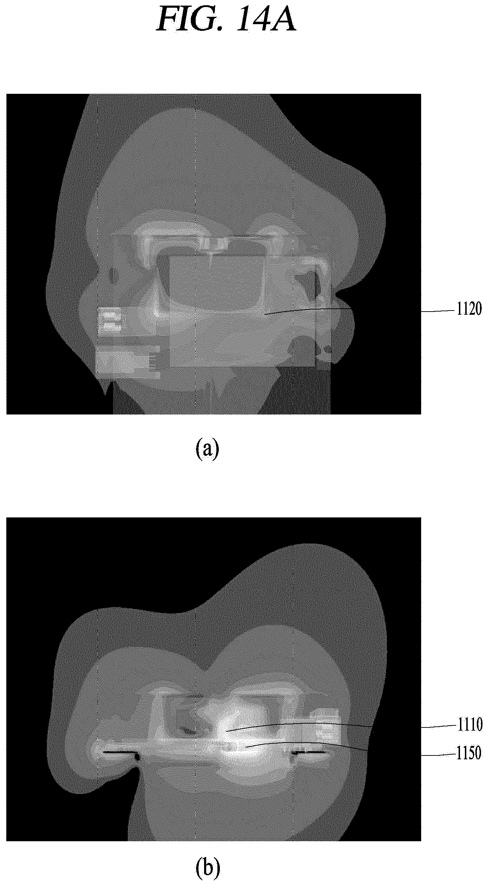

FIG. 14A illustrates an electric field distribution on the front surface and the first side surface the antenna element at a first frequency, i.e., a particular frequency in a fourth band higher than the third band. In relation to this, the fourth band may be the very high band (VHS) of the 4G/5G communication system, but is not limited thereto. As one example, FIG. 14A illustrates an electric field distribution at about 3500 MHz, i.e., a particular frequency in the fourth band higher than the third band. Meanwhile, the very high band (VHB) of the 4G/5G communication system corresponding to the fourth band may be set to a frequency range of about 3300 MHz to 5000 MHz, but is not limited thereto.

Referring to FIG. 9A, and (a) of FIG. 14A, a current value according to an electric field distribution in the second conductive part 1120 on the front surface of the antenna element 1100 is shown as being at a certain level or lower. Referring to FIG. 9A and (b) of FIG. 14A, a current value according to an electric field distribution in the first conductive part 1110 and the third conductive part 1150 on the first side surface of the antenna element 1100 is shown as being at a certain level or higher. Thus, the antenna element 1100 may be configured to radiate a third signal through the first conductive part 1110 and the third conductive part 1150 at a low frequency in the fourth band. Accordingly, the antenna element 1100 may be configured so that a loop radiator and a PCB patch operate as main radiators at a low frequency in the fourth band.

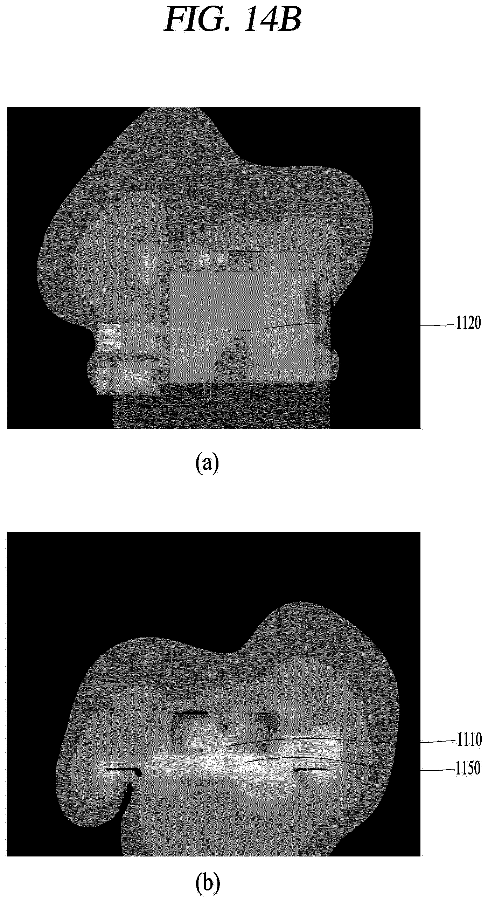

FIG. 14B illustrates an electric field distribution on the front surface and the first side surface of the antenna element at a second frequency, i.e., a particular frequency in the fourth band higher than the third band. In relation to this, the fourth band may be the high band (MB) of the 4G/5G communication system, but is not limited thereto. As one example, FIG. 14B illustrates an electric field distribution at about 4500 MHz, i.e., a particular frequency in the fourth band higher than the third band. As described above, the very high band (VHB) of the 4G/5G communication system corresponding to the fourth band may be set to a frequency range of about 3300 MHz to 5000 MHz, but is not limited thereto.

Referring to FIG. 9A, and (a) of FIG. 14B, a current value according to an electric field distribution in the second conductive part 1120 on the front surface of the antenna element 1100 is shown as being at a certain level or lower. Referring to FIG. 9A and (b) of FIG. 14B, a current value according to an electric field distribution in the first conductive part 1110 on the first side surface of the antenna element 1100 is shown as being at a certain level or lower On the other hand, a current value according to an electric field distribution in the third conductive part 1150 of the antenna element 1100 is shown as being at a certain level or higher. Thus, the antenna element 1100 may be configured to radiate a third signal through the first conductive part 1110 and the third conductive part 1150 in the fourth band. Accordingly, the antenna element 1100 may be configured so that a PCB pattern operates as a main radiator at a high frequency in the fourth band.

Meanwhile, the antenna element 1100 disposed in the vehicle antenna module disclosed herein may be implemented as a plurality of antenna elements placed in different locations on the PCB 1200. In this regard, referring to FIGS. 5 and 6, the antenna element 1110 may be configured to include the first antenna 1100-1 and the second antenna 1100-2. The first antenna 1100-1 may be placed in one side region of the PCB 1200. The second antenna 1100-2 may be placed in another side region of the PCB 1200 to be symmetrical to the first antenna 1100-1.

Meanwhile, the vehicle antenna module 1000 may be configured to further include other antenna elements in addition to the first antenna 1100-1 and the second antenna 1100-2. In this regard, the vehicle antenna module 1000 may be configured to further include at least one of a GNSS antenna 1100-3 and a Wi-Fi antenna 1100-4. The GNSS antenna 1100-3 may be disposed to be apart from one side end of a second radiation structure 1120 of the first antenna 1100-1. The GNSS antenna 1100-3 may be configured to include an upper radiator UR and a vertical connection portion VCP. The vertical connector VCP may be disposed to be vertically connected to the upper radiator UR. The GNSS antenna 1100-3 may further include a feed portion F3 bent at an end of the vertical connection portion VCP to be connected to the PCB 1200.

A Wi-Fi antenna 1100-4 may be placed between the first antenna 1100 and the GNSS antenna 1100-3. The Wi-Fi antenna 1100-4 may be configured as a side surface radiator SSR. The side surface radiator SSR may be configured as a metal structure having a certain width and a certain length with a slot region, but is not limited thereto. The Wi-Fi antenna 1100-4 may further include a feed portion F4 bent at an end of the side surface radiator SSR to be connected to the PCB 1200.

Referring to FIGS. 5 to 10B, the second conductive part 1120 of the first antenna 1100-1 may be disposed to be bent at an upper end of the first metal pattern in one direction. In addition, similarly to the first antenna 1100-1, the second antenna 1100-2 may be configured to include the first conductive part 1110 and the second conductive part 1120. The first conductive part 1110 may be disposed to be perpendicular to the PCB 1200 within a predetermined angle range. The first conductive part 1110 may be configured such that the first metal pattern has a loop shape. The second conductive part 1120 may be disposed to be bent at an upper end of the first metal pattern to another direction opposite to the one direction. The second conductive part 1120 may have a second metal pattern disposed to be in parallel with the PCB 1200.

Meanwhile, the network access device (NAD) 1400 corresponding to a processor may be disposed on the PCB 1200 placed in the vehicle antenna module 1000 disclosed herein. In this regard, referring to FIGS. 5 and 6, the NAD 1400 may be disposed on a front surface of the PCB 1200, but is not limited thereto.

The NAD 1400 may be configured to apply a signal to at least one of the first antenna 1100-1 and the second antenna 1100-2. A transceiving circuit may be disposed between the NAD 1400 and the first antenna 1100-1 and the second antenna 1100-2. The transceiving circuit may be configured to control first and second signals which are transmitted to the first antenna 1100-1 and the second antenna 1100-2, respectively.

The NAD 1400 may be configured to determine whether quality of a signal received through the first antenna 1100-1 is equal to or below a threshold value. When the quality of the signal received through the first antenna 1100-1 is equal to or below the threshold value, the NAD 1400 may control to apply a signal to the second antenna 1100-2 so that a signal is transmitted or received through the second antenna 1100-2.

Meanwhile, when the quality of the signal received through the first antenna 1100-1 is equal to or below the threshold value or the quality of the signal is lower than quality of a previously received signal, the NAD 1400 may control the first antenna 1100-1 and the second antenna 1100-2 to operate in a diversity mode. Thus, the NAD 1400 may control to apply a first signal and a second signal which are transmitted to the first antenna 1100-1 and the second antenna 1100-2, respectively. Accordingly, when the quality of the signal received through the first antenna 1100-1 is equal to or below the threshold value, the NAD 1400 may apply a signal to the second antenna 1100-2 to receive a signal through the second antenna 1100-2.

Meanwhile, the NAD 1400 may perform multiple input/output (MIMO) or diversity operation through the first antenna 1100-1 and the second antenna 1100-2 in the first band. When quality of a first signal in the first band is equal to or below the threshold value, the NAD 1400 may control at least one of the first antenna 1100-1 and the second antenna 1100-2 to use another band, i.e., the second band. When the quality of the first signal in the first band is equal to or below the threshold value, the NAD 1400 may perform multiple input/output (MIMO) or diversity operation through the first antenna 1100-1 and the second antenna 1100-2 in the second band.

Meanwhile, the vehicle antenna module 1000 disclosed herein may have a dielectric mold structure disposed on the lower cover 1300. In this regard, referring to FIGS. 5 and 6, the vehicle antenna module 1000 may further include a dielectric mold 1310. The dielectric mold 1310 may be disposed to correspond to regions in which the first antenna 1100-1 and the second antenna 1100-2 are disposed. The regions in which the first antenna 1100-1 and the second antenna 1100-2 are disposed may correspond to a first region R1 and a second region R2 on the PCB 1200, respectively. The dielectric mold 1310 may be attached to respective regions of the lower cover 1300 corresponding to the first region R1 and the second region R2 on the PCB 1200.

Meanwhile, the vehicle antenna module 1000 disclosed herein may be placed on or inside the roof of the vehicle 500 as shown in FIGS. 3A to 3C. As another example, the vehicle antenna module 1000 disclosed herein may be implemented in a form of a dashboard or an instrumental panel of the vehicle 500, as shown in FIGS. 1A and 1B.

In this regard, the vehicle antenna module 1000 disclosed herein may be placed in different locations in the vehicle 500, i.e., inside (or on) the roof of the vehicle or on an instrument panel (or a dashboard) of the vehicle. As one example, the vehicle antenna module 1000 may be mounted on the instrument panel inside the vehicle or on the roof outside the vehicle. Accordingly, the vehicle antenna module 1000 according to the present disclosure needs to satisfy antenna performance at different locations in the vehicle with different ground environments.

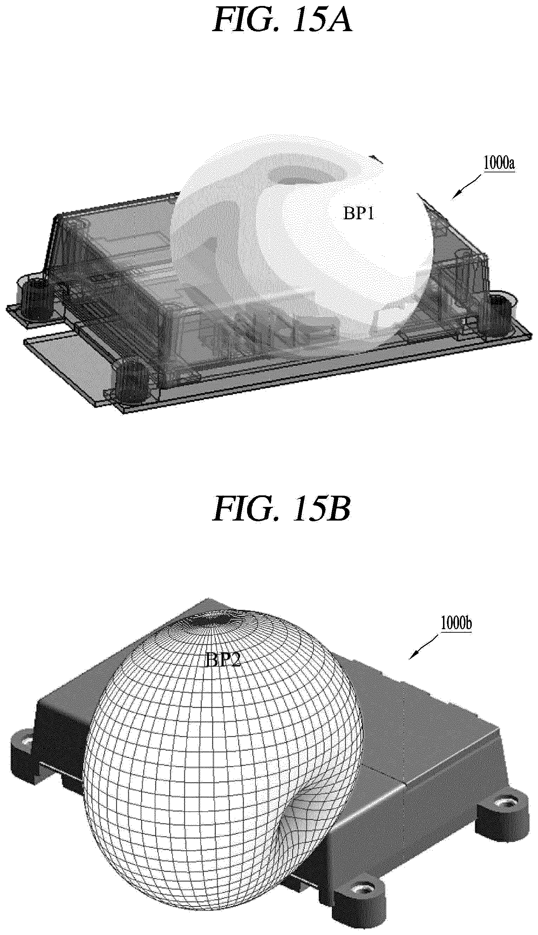

In this regard, FIG. 15A illustrates an antenna module 1000a that may be placed on or inside a roof of a vehicle, and a required low elevation beam pattern. Meanwhile, FIG. 15B illustrates an antenna module 1000b that may be placed on a dashboard or an instrument panel of a vehicle, and a required bore-sight beam pattern. Although the antenna modules 1000a and 1000b of FIGS. 15A and 15B are illustrated as having a structure in which a lower cover is combined with an upper cover, internal antennas may be configured partially differently.

Referring to FIG. 15A and (a) of FIG. 15B, the antenna module 1000a having a roof top mounting structure defines a low elevation beam pattern BP1. In relation to this, since a large ground area implemented using metal in a lower cover or a roof region of the vehicle is adjacent to a lower end of an antenna, wireless performance may deteriorate to a certain degree. Meanwhile, an antenna radiation pattern may be defined toward sky. However, it is important to define a low elevation beam pattern within a predetermined angular range relative to a horizontal plane of the vehicle to perform wireless communications with other vehicles or entities outside the vehicle. Accordingly, it is important to the antenna module 1000a to define a low elevation beam pattern and obtain antenna efficiency on a metal structure in the vehicle.

Referring to FIG. 15A and (b) of FIG. 15B, the antenna module 1000b having a structure mounted inside an instrumental panel of a driver's seat inside the vehicle defines a bore-sight beam pattern BP2. According to a vehicle type, metal or components are randomly distributed in a periphery of an antenna located inside the vehicle. Accordingly, overall efficiency of the antenna functions as an important factor. Additionally, to perform wireless communication throughout an entire space inside the vehicle, performance of free space total efficiencies of an antenna through whole areas is important.

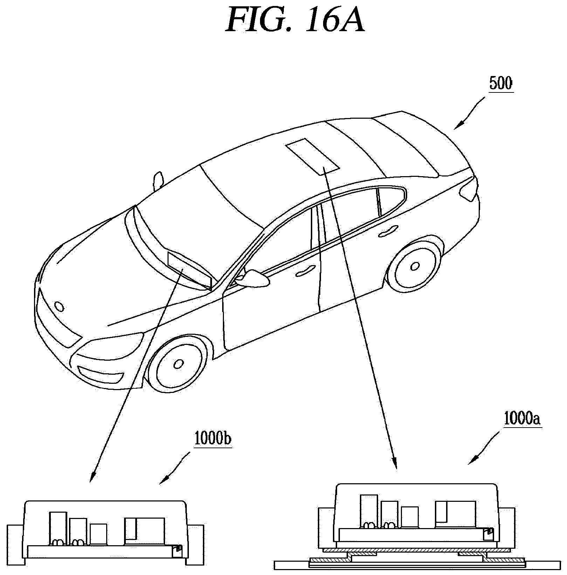

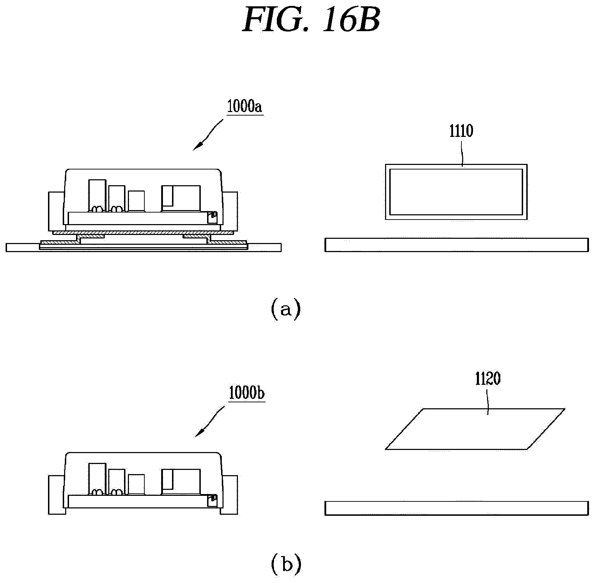

Meanwhile, the vehicle antenna module 1000 disclosed herein may be configured to have a roof top mounting structure and an instrumental panel mounting structure. In relation to this, FIG. 16A illustrates a configuration of the vehicle in which antenna modules having a roof top mounting structure and an instrument panel mounting structure according to the present disclosure are disposed. Meanwhile, FIG. 16B illustrates an antenna equivalent structure of the antenna modules having the roof top mounting structure and the instrument panel mounting structure.

Referring to FIG. 16A, a first antenna module 1000a may be disposed on or inside a roof structure of the vehicle 500. In addition, a second antenna module 1000b may be placed inside an instrument panel of the vehicle 500. Referring to FIG. 16A and (a) of FIG. 16B, the first antenna module 1000a is regarded as having the first conductive part 1110 in a loop shape disposed on a ground structure corresponding to a vehicle roof structure. Referring to FIG. 16A and (b) of FIG. 16B, the second antenna module 1000b is regarded as having the second conductive part 1120 in a wide planar shape disposed on a ground structure corresponding to the vehicle roof structure.

Referring to (a) of FIG. 7, FIG. 15A, FIG. 16A, and (a) of FIG. 16B, the first antenna module 1000a has a structure in which the first conductive part 1110 in a vertical loop shape is disposed on a ground structure corresponding to a vehicle roof structure. Such a vertical loop radiator may minimize antenna performance deterioration caused by the ground structure.

Referring to (b) of FIG. 7, FIG. 15B, FIG. 16A, and (b) of FIG. 16B, the second antenna module 1000b has a structure in which the second conductive part 1120 in a wide planar shape is disposed on a ground structure corresponding to the vehicle roof structure. Antenna performance may be improved by a radiator having such a wide planar shape. Particularly, since this structure may be regarded as a structure in which a patch radiator is arranged on ground, the second antenna module 1000b may define a bore-sight beam pattern BP2.

Meanwhile, the vehicle antenna module 1000 according to the present disclosure may be configured to have a structure in which the first conductive part 1110 is combined with the second conductive part 1120 as shown in (c) of FIG. 7. Accordingly, the vehicle antenna module 1000 may be configured as a loop hybrid antenna in which a loop shape is combined with a patch shape to operate as an antenna both in a ground structure such as a metal structure and in a free space area.

As one example, when placed on a roof structure of the vehicle, the vehicle antenna module 1000 may be configured as the first antenna module 1000a of the first conductive part 1110. In addition, the antenna module 1000 may be configured as the second antenna module 1000b of the second conductive part 1120 when placed inside the vehicle.

As another example, the vehicle antenna module 1000 may be configured to have a structure in which the first conductive part 1110 is combined with the second conductive part 1120 as shown in (c) of FIG. 7 to be disposed both on the roof structure of the vehicle and inside the vehicle.

In relation to this, when the vehicle antenna module 1000 is placed on the roof structure of the vehicle, a frequency equal to or higher than a particular frequency in the 4G/5G communication band may be used. Accordingly, the vehicle antenna module 1000 may operate in a loop radiator mode. In this regard, referring to FIGS. 12C to 14B, the vehicle antenna module 1000 may operate in a loop radiator mode using a frequency in the mid band (MB) or higher among 4G/5G communication bands. Accordingly, when the vehicle antenna module 1000 is placed outside the vehicle, the low elevation beam pattern BP1 of FIG. 15A may be constituted. However, even when the vehicle antenna module 1000 is placed outside the vehicle, communication with other vehicles or entities outside the vehicle may be performed using a frequency in the low band (LB) among the 4G/5G communication bands.

On the other hand, when the vehicle antenna module 1000 is placed inside a vehicle, a frequency equal to or below a particular frequency in the 4G/5G communication bands may be used. Accordingly, the vehicle antenna module 1000 may operate in a patch radiator mode. In relation to this, referring to FIGS. 12A and 12B, the vehicle antenna module 1000 may operate in a patch radiator mode using a frequency in the mid band (MB) among the 4G/5G communication bands. Accordingly, when the vehicle antenna module 1000 is placed inside the vehicle, the bore-sight beam pattern BP2 of FIG. 15B may be constituted.

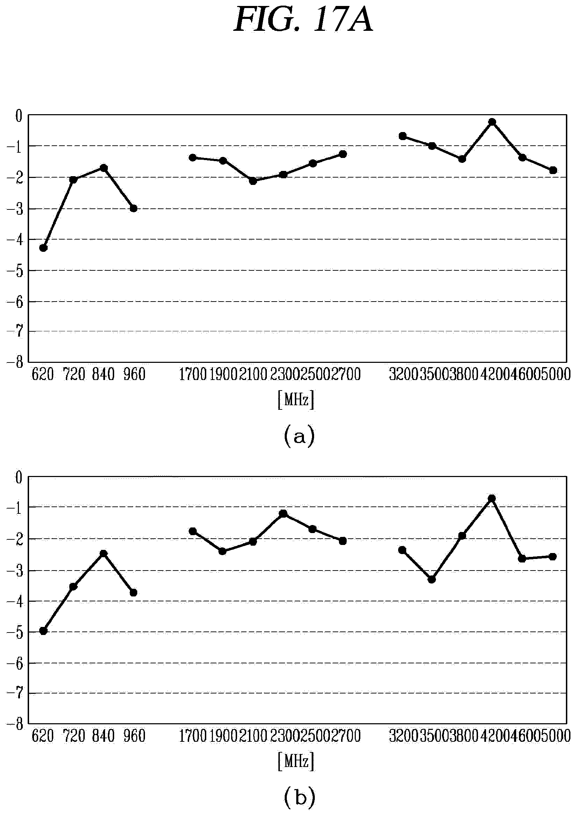

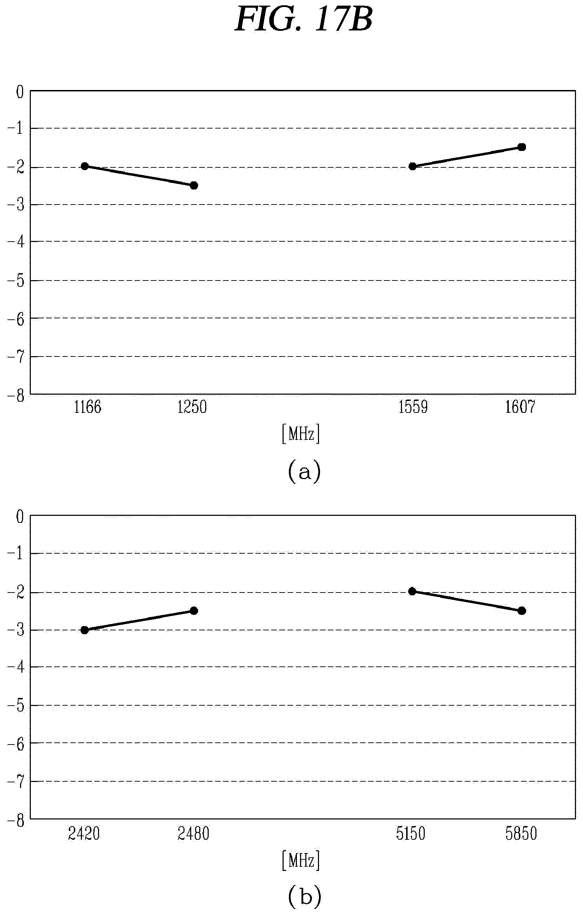

Meanwhile, the vehicle antenna module according to the present disclosure may be implemented to have high antenna efficiency in a full 4G/5G communication band, a GNSS band, and a Wi-Fi band. In this regard, FIGS. 17A and 17B show antenna efficiencies for each frequency with respect to each antenna element in the vehicle antenna module according to the present disclosure. Referring to FIGS. 5 to 10B, 17A and 17B, a frequency range in which the first antenna 1100-1 and the second antenna 1100-2 operate as radiators may be 617 to 5000 MHz, but is not limited thereto. A frequency band in which the GNSS antenna 1100-3 operates as a radiator may be a L1/L5 band, but is not limited thereto. A frequency band in which the Wi-Fi antenna 1100-4 operates as a radiator may be a 2.4 GHz band and a 5 GHz band, but is not limited thereto.

Referring to FIGS. 5 to 10B and (a) of FIGS. 17A, efficiency of the first antenna 1100-1 operating in a full 4G/5G communication band is expressed in dB units. Referring to FIGS. 5 to 10B and (b) of FIGS. 17A, efficiency of the second antenna 1100-2 operating in the full 4G/5G communication band is expressed in dB units.

Referring to FIGS. 5 to 10B and FIGS. 17A, the first antenna 1100-1 and the second antenna 1100-2 have antenna efficiencies equal to or greater than a threshold value in the first to third bands. In this regard, a total antenna gain needed in the first band, which is the low band (LB), is approximately -5 dB or higher, and an average gain at a low elevation may be -6.5 dBi or higher. Antenna gains needed in the mid band (MB) and the high band (HB) in the second band may be approximately -3 dB and -4 dB, respectively, and average gains at a low elevation may be approximately -3.5 dBi and -5 dBi or higher, respectively. An antenna gain needed in the third band, i.e., the very high band (VHB) may be about -3.5 dB, and an average gain at a low elevation may be about -5 dBi or higher.

Antenna efficiencies for respective frequencies of the first antenna 1100-1 and the second antenna 1100-2 may have different values to a certain degree. This is because an arrangement structure of one side region of the PCB 1200 in which the first antenna 1100-1 is disposed is different from that of another side region in which the second antenna 1100-2 is disposed to a certain degree. However, the first antenna 1100-1 and the second antenna 1100-2 have antenna efficiencies equal to or higher than the threshold value in the first to third bands, and thus, operate as radiators in the full 4G/5G communication band.

Referring to FIGS. 5 to 10B and (a) of FIG. 17B, the GNSS antenna 1100-3 has an antenna efficiency equal to or higher than a threshold value in the L1/L5 band. In the L5 band from 1166 to 1250 MHz, the GNSS antenna 1100-3 has an antenna efficiency of -2.0 to -2.5 dB, which is higher than a required value of -3 dB or higher. In the L1 band from 1559 to 1607 MHz, the GNSS antenna 1100-3 has an antenna efficiency of -1.5 to -2.0 dB, which is higher than a required value of -3 dB or higher.

Referring to FIGS. 5 to 10B and (b) of FIG. 17B, the Wi-Fi antenna 1100-4 has an antenna efficiency equal to or higher than a threshold value in a 2.4GHz band and a 5 GHz band. In a band of 2420 to 2480 MHz, the Wi-Fi antenna 1100-4 has an antenna efficiency of -7 dB or higher in each direction and -5 dB or higher in all directions. In a band of 5150 to 5180MHz, the Wi-Fi antenna 1100-4 has an antenna efficiency of -9 dB or higher in each direction and -4 dB or higher in all directions. In relation to this, each direction includes a front direction, a left side direction, a right side direction, and a rear direction.

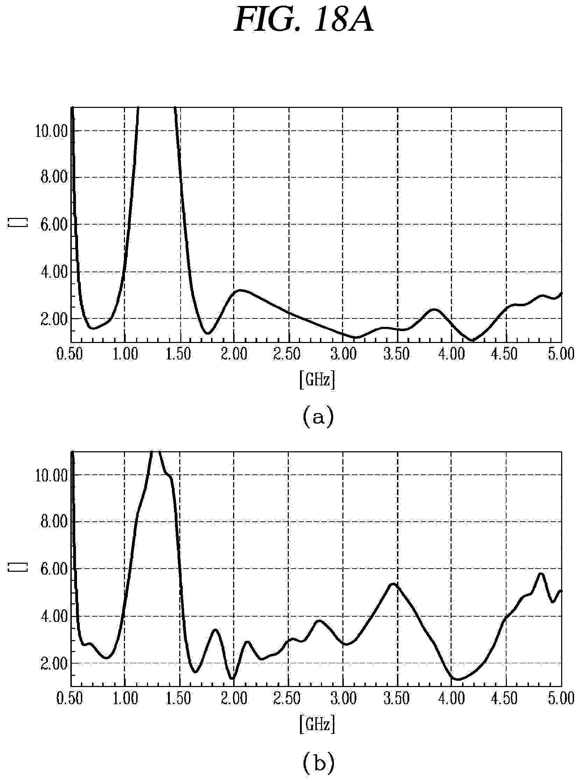

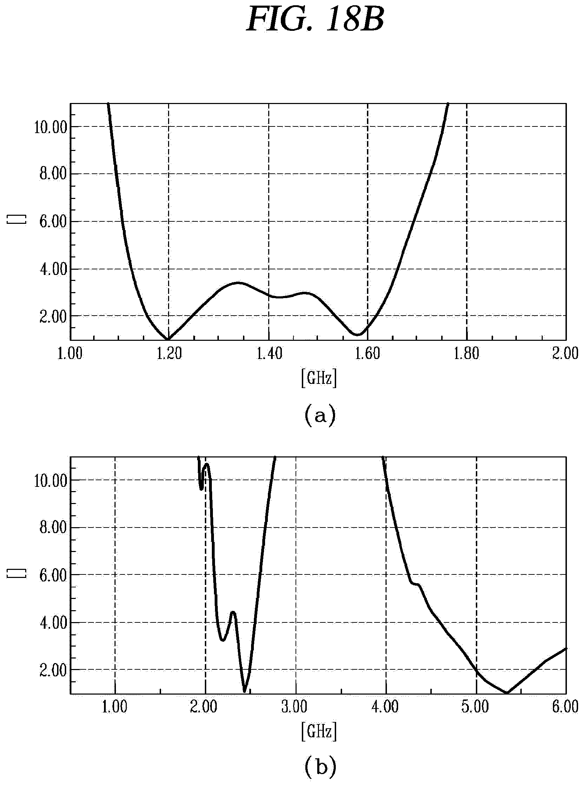

Meanwhile, the vehicle antenna module according to the present disclosure may be implemented to have a lower VSWR in the full 4G/5G communication band, the GNSS band, and the Wi-Fi band. In relation to this, FIGS. 18A and 18B illustrate a VSWR for each frequency with respect to each antenna element in the vehicle antenna module according to the present disclosure.

Referring to FIGS. 5 to 10B and (a) of FIGS. 18A, a VSWR of the first antenna 1100-1 operating in the full 4G/5G communication band is expressed in dB units. Referring to FIGS. 5 to 10B and (b) of FIGS. 18A, a VSWR of the second antenna 1100-2 operating in a full 4G/5G communication band is expressed in dB units. Referring to FIGS. 5 to 10B, (a) of FIGS. 18A, and (b) of FIGS. 18A, the first antenna 1100-1 and the second antenna 1100-2 have VSWRs equal to or greater than a threshold value, e.g., 3 or less in the first to third bands.

Referring to FIGS. 5 to 10B and (a) of FIG. 18B, a VSWR of the GNSS antenna 1100-3 operating in the L1/L5 band is expressed in dB units. The GNSS antenna 1100-3 has a VSWR of a threshold value, i.e., 3 or less in the L1/L5 band.

Referring to FIGS. 5 to 10B and (b) of FIG. 18B, a VSWR of the first antenna 1100-4 operating in the 2.4 GHz to 5 GHz band is expressed in dB units. The Wi-Fi antenna 1100-4 has a VSWR of a threshold value, i.e., 3 or less in the 2.4 GHz and the 5 GHz band.

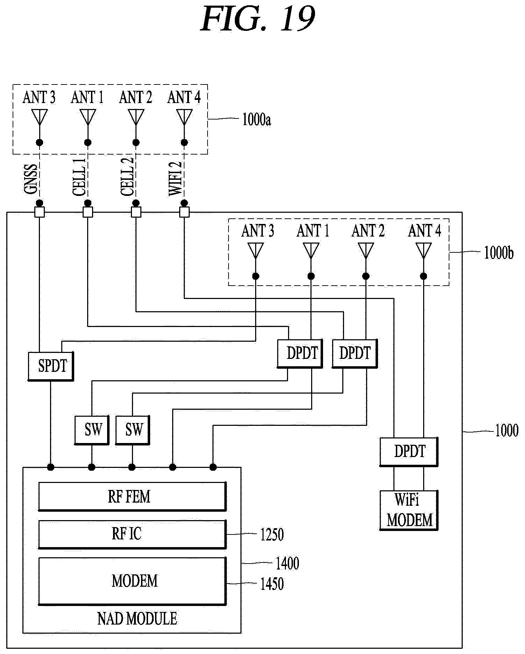

Meanwhile, the vehicle antenna module 1000 according to the present disclosure may be configured to include an external antenna 1000a and an internal antenna 1000b. In relation to this, FIG. 19 illustrates a block diagram of the vehicle antenna module configured to include an external antenna and an internal antenna.

Referring to FIG. 19, the external antenna 1000a may be configured to include a first antenna ANT1 to a fourth antenna ANT4. In this regard, the external antenna 1000a may include the first antenna ANT1 and the second antenna ANT2 operating in the 4G/5G communication band. In addition, the external antenna 1000a may further include the third antenna ANT3 which is a GNSS antenna and the fourth antenna ANT4 which is a Wi-Fi antenna.

In the external antenna 1000a, the first antenna ANT1 and the second antenna ANT2 may be configured to have a structure in which a vertical loop radiator (a first conductive part) is perpendicularly placed on a ground structure. As another example, the external antenna 1000a may be configured to include the first conductive part and a second conductive part as shown in FIGS. 5 to 10B.

The internal antenna 1000b may be also configured to include the first array antenna ANT1 to the fourth array antenna ANT4. In this regard, the internal antenna 1000b may include the first antenna ANT1 and the second antenna ANT2 each operating in the 4G/5G communication band. In addition, the internal antenna 1000b may further include the third antenna ANT3 which is a GNSS antenna and the fourth antenna ANT4 which is a Wi-Fi antenna.

In relation to 4G/5G MIMO operation, the first and second antennas among the external antennas 1000a and the first and second antennas among the internal antennas 1000b may be used. Accordingly, the vehicle antenna module 1000 may perform up to 4x4 MIMO operation using the external antenna 1000a and the internal antenna 1000b. Meanwhile, when only the external antenna 1000a is mounted, 2x2 MIMO operation may be performed using the first antenna ANT1 and the second antenna ANT2 in the external antenna 1000a. On the other hand, when only the internal antenna 1000b is mounted, 2x2 MIMO operation may be performed using the first antenna ANT1 and the second antenna ANT2 in the internal antenna 1000b.

Each of the first antenna ANT1 and the second antenna ANT4 may be operably coupled to a double pole double throw (DPDT) switch to perform 4G/5G MIMO operation using both the external antenna 1000a and the internal antenna 1000b. Meanwhile, the third antenna ANT3 may also be operably coupled to a DPDT switch to perform Wi-Fi MIMO operation using both the external antenna 1000a and the internal antenna 1000b. On the other hand, the external antenna 1000a or the internal antenna 1000b may be selected for GPS positioning. Accordingly, the third antenna ANT3 which is a GNSS antenna may be operably coupled to a single pole double throw (SPDT) switch to select the external antenna 1000a or the internal antenna 1000b.

In relation to the GPS positioning operation, depending on an environment in which the antenna module is mounted, the third antenna ANT3 in the external antenna 1000a and/or the third antenna ANT3 among the internal antenna 1000b may be selectively used. In relation to Wi-Fi communication operation, depending on an environment in which the antenna module is mounted, the fourth antenna ANT4 among the external antennas 1000a and/or the fourth antenna ANT4 among the internal antenna 1000b may be selectively used.

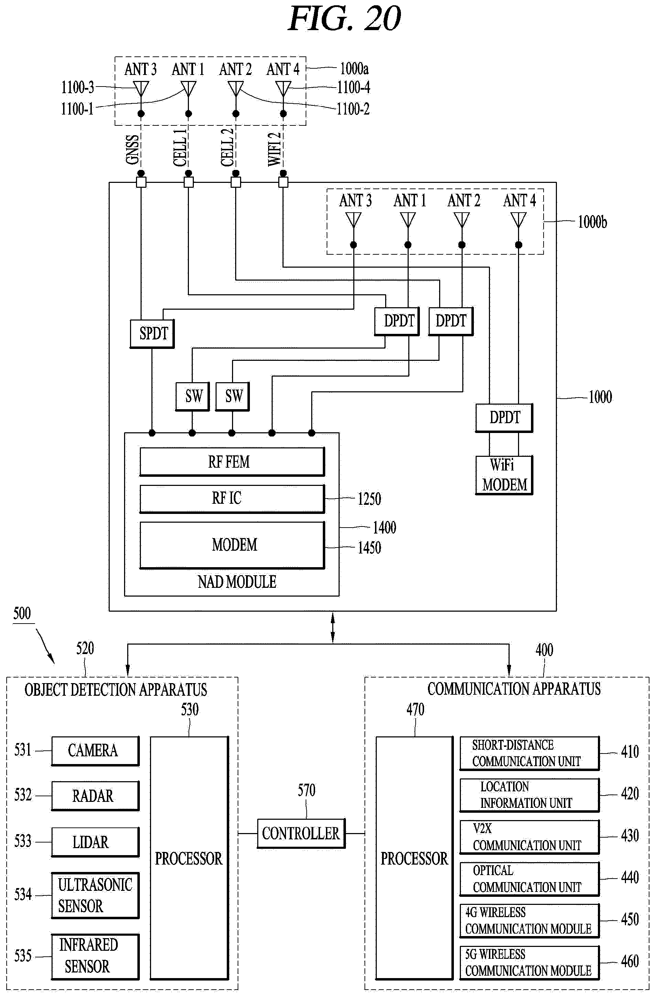

Meanwhile, FIG. 20 is a block diagram illustrating the antenna module according to an embodiment and a vehicle on which the antenna module is mounted. In detail, FIG. 20 is a block diagram of a vehicle performing communication with peripheral electronic devices, vehicles, and infrastructures by having an antenna module corresponding to an antenna system disposed inside a roof of the vehicle.

Referring to FIG. 20, the antenna module 1000 may be mounted in the vehicle, and the antenna system 1000 may perform short-range communication, wireless communication, V2X communication, etc. independently or through the communication apparatus 400. To do so, the baseband processor 1400 may perform control such that a signal is received from or transmitted to an adjacent vehicle, a RSU, and a base station through the antenna assembly 1000.

Alternatively, the baseband processor 1400 may perform control such that a signal is received from or transmitted to an adjacent vehicle, an RSU, an adjacent object, or a base station through the communication apparatus 400. Here, information related to adjacent objects may be acquired through an object detecting apparatus such as a camera 531, a radar 532, a LiDar 533, and sensors 534 and 535 each included in a vehicle 300. Alternatively, the baseband processor 1400 may perform the communication apparatus 400 and the antenna module 1000 to receive or transmit a signal from/to an adjacent vehicle, an RSU, an adjacent object, and a base station.

Referring to FIGS. 1A to 20, the vehicle 500 having the antenna assembly 1000 may be configured to include a plurality of antennas 1100, the transceiving circuit 1250, and the baseband processor 1400. Meanwhile, the vehicle 500 may further include the object detecting apparatus 520. The vehicle 500 may further include the communication apparatus 400. Here, the communication apparatus 400 may be configured to perform wireless communication through an antenna unit.

Referring to FIGS. 1A to 20, the vehicle 500 may include the antenna module 1000. The antenna module 1000 may be disposed on a roof structure of the vehicle or inside the vehicle, and configured to communicate with at least one of an adjacent vehicle, an RSU, and a base station through a processor. Since the antenna module 1000 performs telematics operations through wireless communication in the vehicle, the antenna module 1000 may also be referred to as a telematics module. As another example, a PCB separate from the PCB 1200 may be implemented as a telematics module.

Hereinafter, the vehicle 500 having the antenna module 1000 according to another aspect of the present disclosure is described with reference to FIGS. 1A to 20. The vehicle 500 includes the antenna module 1000 disposed below a roof of the vehicle. The vehicle 500 may further include the processor 1400 disposed inside or outside the antenna module 1000 and configured to communicate with at least one of an adjacent vehicle, an RSU, and a base station.

The antenna module 1000 mounted in the vehicle may be configured to include the antenna element 1100, the PCB 1200, the lower cover 1300, and the upper cover 1300u. The antenna module 1000 may include the PCB 1200 on which electronic components are arranged. The antenna module 1000 may include the antenna element 1100 connected to a metal pattern on the PCB 1200 and configured to radiate a wireless signal. The antenna module 1000 may include the lower cover 1300 disposed below the PCB 1200 and made of a metal plate. The antenna module 1000 may include the upper cover 1300 combined with the lower cover 1300 and configured to accommodate the PCB 1200 and the antenna element 1100 therein.

The antenna element 1100 may include the first conductive part 1100 disposed to be perpendicular to the PCB within a predetermined angle range and having a first metal pattern with a loop shape. The antenna element 1100 may include the second conductive part 1120 having a second metal pattern disposed in parallel with the PCB 1200.

As one example, the antenna element 1100 may be configured to include the first conductive part 1100 and the second conductive part 1120. In relation to this, the second conductive part 1120 may have a second metal pattern disposed at an upper end of the first metal pattern of the first conductive part 1100 to be in parallel with the PCB 1200.

Accordingly, the antenna element 1100 may be configured to radiate a first signal through the second conductive part 1120 in the first band. Additionally, the antenna element 1100 may be configured to radiate a second signal through the first conductive part 1100, i.e., a loop radiator structure in the second band higher than the first band.

The antenna element 1100 may include the feeding structure 1130 configured to extend from an upper end of the first separation point P1 of a lower pattern of the first metal pattern to be connected to the signal pattern SP of the PCB 1200. The antenna element 1100 may further include the short-circuit structure 1140 configured to extend from an upper end of the second separation point P2 of the lower pattern of the first metal pattern to be connected to the ground pattern GP of the PCB 1200.

The feeding structure 1130 may be configured to extend from an upper end of the first separation point P1 of the lower pattern of the first metal pattern to be connected to the first feed pattern 1131 disposed in parallel with the PCB 1200. The feeding structure 1130 may include the second feed pattern 1132 disposed at an end of the first feed pattern 1131 to be perpendicular to the first feed pattern 1131. The feeding structure 1130 may include the third feed pattern 1133 disposed at an end of the second feed pattern 1132 to be perpendicular to the feeding structure 1130 and configured to be connected to the signal pattern SP of the PCB 1200.

Meanwhile, the short circuit structure 1140 may also be configured to correspond to a shape of the feeding structure 1130. In relation to this, the short circuit structure 1140 may be configured to include the first short circuit pattern 1141 to the third short circuit pattern 1143.

The antenna element 1100 may operate as the first antenna 1100-1 placed on one side region of the PCB 1200. The second conductive part 1120 of the first antenna 1100-1 may be disposed to be bent at an upper end of the first metal pattern in one direction. The antenna element 1100 may further include the second antenna 1100-2 disposed in another side region of the PCB 1200 to have a structure symmetrical to the first antenna 1100-1.

The second antenna 1100-2 may include the first conductive part 1110 disposed to be perpendicular to the PCB 1200 within a predetermined angle range and having a first metal pattern with a loop shape. The second antenna 1100-2 may include the second conductive part 1120 having a second metal pattern disposed in parallel with the PCB 1200.

The processor 1400 may be disposed on the PCB 1200 adjacent to the first antenna 1100-1 and may be operably combined with the first antenna 1100-1 and the second antenna 1100-2. Accordingly, when quality of a signal received through the first antenna 1100-1 is equal to or less than a threshold value, the processor 1400 may apply a signal to the second antenna 1100-2 so that a signal is received through the second antenna 1100-2.

Meanwhile, the transceiving circuit 1250 may be operably coupled to each antenna element 1100. The processor 1400 may be operably coupled to the transceiving circuit 1250. The processor 1400 may be a baseband processor corresponding to a modem, but is not limited thereto and may be any processor configured to control the transceiving circuit 1250. The processor 1400 of the vehicle may be implemented as a network access device (NAD).

Referring to FIG. 18, the transceiving circuit 1250 may be operably coupled to MIMO antennas ANT1 to ANT4. In this regard, some MIMO antennas ANT1 and ANT2 among the MIMO antennas may be configured as external antennas 1000a. Meanwhile, other antennas ANT3 and ANT4 among the MIMO antennas may be configured as the internal antennas 1000b.

The transceiver circuitry 1250 may include a front end module (FEM) such as a power amplifier or a receiving amplifier. As another example, the front end module (FEM) may be disposed between the transceiver circuitry 1250 and the antenna, separately from the transceiver circuitry 1250. The transceiver circuitry 1250 may control the amplitude and/or phase of signals transmitted to the MIMO antennas ANT1 to ANT4 or control only some antenna modules to operate by adjusting the gain or input or output power of the power amplifier or the receiving amplifier.

The processor 1400 may be operably coupled to the transceiver circuitry 1250 and may be configured to control the transceiver circuitry 1250. The processor 1400 may control the transceiver circuitry 1250 to control the amplitude and/or phase of the signals transmitted to the MIMO antennas ANT1 to ANT4 or to operate only some antenna modules. The processor 1400 may perform communication with at least one of the adjacent vehicle, the RSU, and the base station through the transceiver circuitry 1250.

In a case where there is a need to simultaneously receive information from various entities such as the adjacent vehicle, the RSU, and the base station for autonomous driving, etc., information may be received and transmitted through MIMO. Accordingly, the vehicle may improve its communication capacity by receiving different information from various entities at the same time. Therefore, the communication capacity of the vehicle can be improved through the MIMO without increasing a bandwidth.

Alternatively, the vehicle may simultaneously receive the same information from various entities, so as to improve reliability of surrounding information and decrease latency. Accordingly, ultra reliable low latency communication (URLLC) can be performed in the vehicle and the vehicle can operate as a URLLC UE. To this end, a base station that performs scheduling may preferentially allocate a time slot for the vehicle operating as the URLLC UE. For this, some of specific time-frequency resources already allocated to other UEs may be punctured.

As described above, the plurality of antennas ANT1 to ANT4 for 4G/5G communication within the antenna module 1000 may operate in the full band including the low band (LB), the mid band (MB), and the high band (HB). Here, the low band (LB) may be referred to as the first (frequency) band and the mid band (MB) and the high band (HB) may be referred to as the second (frequency) band. As another example, when the antenna module 1000 operates in the mid band (MB) and the high band (HB), the middle band (MB) is referred to as a first (frequency) band and the high band (HB) is referred to as a second (frequency) band. The 5G Sub6 band may be the same band as the LTE band in case of LTE re-farming. When 5G NR operates in a band separate from LTE, it may operate in the high band (HB) or a higher band. The 5G Sub6 band operating in the high band (HB) or higher band may also be referred to as a second (frequency) band.

The baseband processor 1400 may perform MIMO through some of the plurality of antennas ANT1 to ANT4 in the first frequency band. Also, the baseband processor 1400 may perform MIMO through some of the plurality of antennas ANT1 to ANT4 in the second frequency band. In this regard, the baseband processor 1400 may perform MIMO by using antenna elements that are sufficiently spaced apart from each other and disposed by being rotated at a predetermined angle. This may improve isolation between the first and second signals within the same band.

The baseband processor 1400 may control the transceiver circuitry 1250 to receive the second signal of the second frequency band while receiving the first signal of the first frequency band through one of the first to fourth antennas ANT1 to ANT4. In this case, there may be an advantage that the baseband processor 1400 can perform carrier aggregation (CA) through one antenna.

Alternatively, the baseband processor 1400 may control the transceiver circuitry 1250 to receive the first signal of the second band through any one of the third antenna ANT3 and the fourth antenna ANT4 while receiving the first signal of the first band through any one of the first antenna ANT1 and the third antenna ANT2. In this case, there may be an advantage in that each antenna can be designed to optimally operate in a corresponding band.

Therefore, the baseband processor 1400 may perform carrier aggregation (CA) through a combination of the first frequency band and the second frequency band. When it is necessary to receive a large amount of data for autonomous driving or the like, reception in a broad band can be allowed through the CA.

Accordingly, enhanced mobile broad band (eMBB) communication may be performed in the vehicle and the vehicle can operate as an eMBB UE. To this end, a base station performing scheduling may preferentially allocate broadband frequency resources for the vehicle operating as the eMBB UE. To this end, the CA may be performed on frequency bands that are available, except for frequency resources already allocated to other UEs.

Regard the frequency band, the low band (LB), the mid band (MB), and the high band (HB) may be referred to as the first band, the second band, and the third band, respectively. The antenna system 1000 may operate as a single antenna in the first band, the second band, and the third band corresponding to the low band (LB), the middle band (MB), and the high band (HB). In this regard, the processor 1400 may determine a resource region allocated through a physical downlink control channel (PDCCH). The processor 1400 may control the transceiver circuitry 1250 to perform carrier aggregation in two or more of the first to third bands based on the allocated resource region.

The processor 1400 may perform MIMO in an EN-DC state through the first to fourth antennas ANT1 to ANT4. For example, the processor 1400 may perform an EN-DC operation through the first antenna ANT1 and the second antenna ANT2, and MIMO through the third antenna ANT3 and the fourth radiator ANT4.

In this regard, when the EN-DC operation is performed between 4G/5G communication systems and WiFi communication systems using different bands, the processor 1400 may perform the EN-DC operation through a plurality of antennas in one antenna system. Accordingly, an interference level between MIMO streams using the same band can be reduced. In some examples, when the EN-DC operation is performed between the 4G and 5G communication systems using the same band, the processor 1400 may perform the EN-DC operation through a plurality of antennas in different antenna systems. In this instance, to reduce the interference level in the low band (LB), the MIMO operation through the plurality of antennas in the same antenna system may be performed in the mid band (MB) or higher.

It will be clearly understood by those skilled in the art that various modifications and alternations for the aforementioned implementations related to the antenna system having the plurality of antennas, the vehicle having the antenna system, and the control operations thereof are made without departing from the idea and scope of the disclosure. Therefore, it should be understood that such various modifications and alternations for the implementations fall within the scope of the appended claims.

An antenna module having a broadband antenna mounted in a vehicle and a vehicle having the antenna module mounted therein have been described. Hereinafter, technical effects of an antenna module having a broadband antenna mounted in a vehicle and the vehicle having the antenna module mounted therein are described.

The technical effects of the antenna module having the broadband antenna mounted in the vehicle and the vehicle having the antenna module mounted thereon are described below.

According to the present disclosure, operation may be performed to cover a full 4G/5G low band (LB) through a conductive part having a loop shape.

According to the present disclosure, operation may be performed to cover a full band including a mid band (MB), a high band (HB), and a very high band (VHB) in addition to the low band (LB) for 4G/5G communication through a first conductive part having a loop shape and a second conductive part having a patch shape. The second conductive part may be disposed to be substantially perpendicularly bent from the first conductive part to be parallel with a printed circuit board (PCB).

According to the present disclosure, a conductive part operating in a global navigation satellite system (GNSS) band and in a Wi-Fi band in addition to a full 4G/5G band may be provided in one antenna module. A GNSS antenna and a Wi-Fi antenna may be disposed in a region adjacent to at least one of first and second antennas operating in the full 4G/5G band.

According to the present disclosure, even when a body or a roof exterior of the vehicle is made of a metal material, an antenna module may be disposed to provide a wireless signal to an inner region of a vehicle. Some part of an upper cover of the antenna module and a roof structure of the vehicle may be made of a non-metal material.

According to the present disclosure, an external antenna for vehicle external communication and an internal antenna for vehicle internal communication, placed in different locations in a vehicle, may be provided as one antenna module. An antenna element disposed in the antenna module may be configured such that a first conductive part configured to define a low elevation beam pattern is combined with a second conductive part configured to define a bore-sight beam pattern.

According to the present disclosure, antenna performance may be improved while maintaining a height of an antenna module at a certain level or less. A height of a whole antenna module may be reduced by lowering a height of a first conductive part having a loop shape.

According to the present disclosure, a structure for mounting, in a vehicle, an antenna system capable of operating in a broad band to support various communication systems is provided. In relation to this, MIMO or diversity operation may be performed through first and second antennas configured to operate to cover a full 4G/5G communication band. A GNSS antenna and A Wi-Fi antenna may be placed to be adjacent to one of the first and second antennas.

Further scope of applicability of the disclosure will become apparent from the foregoing detailed description. It should be understood, however, that the detailed description and specific examples, such as the preferred embodiment of the disclosure, are given by way of illustration only, since various modifications and alternations within the spirit and scope of the disclosure will be apparent to those skilled in the art.

In relation to the foregoing description, the antenna module mounted in the vehicle and the operation of controlling the same may be implemented by software, firmware, or a combination thereof. Meanwhile, the design of the antenna system mounted in the vehicle and the configuration of controlling the antenna system may be implemented as computer-readable codes in a program-recorded medium. The computer-readable medium may include all types of recording devices each storing data readable by a computer system. Examples of such computer-readable media may include hard disk drive (HDD), solid status disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the disclosure should be determined by reasonable interpretation of the appended claims and all changes that come within the equivalent scope of the disclosure are included in the scope of the disclosure.

## Claims

1. An antenna module mounted in a vehicle, the antenna module comprising:
a printed circuit board (PCB) on which electronic components are disposed;
an antenna element connected to a metal pattern on the PCB and configured to radiate a radio signal;
a lower cover disposed below the PCB and made of a metal plate; and
an upper cover combined with the lower cover and configured to accommodate the PCB and the antenna element therein;
wherein the antenna element comprises:
a first conductive part disposed to be perpendicular to the PCB within a predetermined angle range and having a first metal pattern in a loop shape; and
a second conductive part having a second metal pattern disposed at an upper end of the first metal pattern to be parallel with the PCB, and
the antenna element is configured to:
radiate a first signal in a first band through the first conductive part and the second conductive part, and
radiate a second signal in a second band other than the first band through the first conductive part.

2. The antenna module of claim 1, wherein the antenna element further comprises:
a feeding structure configured to extend from an upper end of a first separation point of a lower pattern of the first metal pattern to be connected to a signal pattern of the PCB; and
a short-circuit structure configured to extend from an upper end of a second separation point of the lower pattern of the first metal pattern to be connected to a ground pattern of the PCB.

3. The antenna module of claim 1, wherein the feeding structure comprises:
a first feed pattern disposed to extend from an upper end of a first separation point of a lower pattern of the first metal pattern to be parallel with the PCB; and
a second feed pattern disposed at an end of the first feeding pattern to be perpendicular to the first feed pattern; and
a third feed pattern disposed at an end of the second feed pattern to be perpendicular to the second feed pattern and configured to be connected to a signal pattern of the PCB.

4. The antenna module of claim 3, wherein a first slot region is disposed in an upper pattern of the first metal pattern to have a second length greater than a first length of a gap in the lower pattern, and
a second slot region is disposed in one region of the second metal pattern connected to the upper pattern of the first metal pattern to have a third length equal to or greater than the second length.

5. The antenna module of claim 1, wherein a length of a lower pattern of the first metal line of the first conductive part is determined so that the antenna element operates in a low band (LB), and
a sum of the length of the lower pattern and a side length of the first metal line is determined so that the antenna element operates in a mid band (MB).

6. The antenna module of claim 5, wherein a length of one side of the lower pattern of the first metal line is determined so that the antenna element operates in a fifth generation (5G) Sub-6 band, and
a distance between the lower pattern and the upper pattern of the first metal line is determined so that the antenna element operates in a high band (HB).

7. The antenna module of claim 1, wherein the second conductive part comprises:
a first metal region disposed to be connected to the first metal line and configured to have a first width and a first length; and
a second metal region configured to have a second width smaller than the first width,
a total length of the first metal region and the second metal region is configured as a second length, and
the first length and the second length are determined so that the antenna element operates in a mid band (MB) and a low band (LB), respectively.

8. The antenna module of claim 1, wherein the antenna element is configured to:
radiate a first signal at a first frequency in the first band through the second conductive part, and
radiate a signal at a second frequency higher than the first frequency in the first band through the first conductive part and the second conductive part, and
the first band is a low band (LB), and the second band higher than the first band is a mid band (MB) and a high band (HB).

9. The antenna module of claim 1, wherein the antenna element further comprises a third conductive part disposed on the PCB and configured to radiate a third signal in a third band higher than the second band, and
the antenna element is configured to:
radiate a third signal at a first frequency in the third band through the first conductive part and the third conductive part, and
radiate a third signal at a second frequency higher than the first frequency in the third band through the third conductive part.

10. The antenna module of claim 1, wherein the antenna element operates as a first antenna disposed on one side region of the PCB, and the second conductive part of the first antenna is disposed to be bent at an upper end of the first metal pattern in one direction,
the antenna element further comprises a second antenna disposed on another side region of the PCB to have a structure symmetrical to the first antenna, and
the second antenna may comprise:
a first conductive part disposed to be perpendicular to the PCB within a predetermined angle range and configured to have a first metal pattern in a loop shape; and
a second conductive part disposed to be bent at an upper end of the first metal pattern in another direction opposite to the one direction and having a second metal pattern to be parallel with the PCB.

11. The antenna module of claim 10, further comprising:
a global navigation satellite system (GNSS) antenna disposed to be apart from one side end of a second radiation structure of the first antenna and comprising an upper radiator and a connection portion perpendicularly connected to the upper radiator; and
a Wi-Fi antenna disposed between the first antenna and the GNSS antenna, and configured as a side surface radiator.

12. The antenna module of claim 11, further comprising a network access device (NAD) disposed on the PCB to be adjacent to the first antenna and operably coupled to the first antenna and the second antenna, and
when quality of a signal received from the first antenna is equal to or less than a threshold value, the NAD applies a signal to the second antenna to receive a signal through the second antenna.

13. The antenna module of claim 12, wherein the NAD is configured to:
perform multiple input/output (MIMO) or diversity operation in the first band through the first antenna and the second antenna, and
perform MIMO or diversity operation in the second band through the first antenna and the second antenna, when quality of the first signal in the first band is equal to or below a threshold value.

14. The antenna module of claim 10, further comprising a backup battery disposed in the upper cover and configured to supply power to inside of the antenna module,
wherein the first antenna is disposed to be adjacent to one side of an accommodation space of the backup battery, and
the second antenna is located in a lower region of the accommodation space to be disposed to be offset to a lower region further than the first antenna.

15. The antenna module of claim 10, further comprising a dielectric mold attached to regions of the lower cover in correspondence with a first region and a second region on the PCB, respectively, wherein the first antenna and the second antenna are disposed in the first region and the second region, respectively, and
metal in lower portions of the first antenna and the second antenna is configured to be apart from ground by the dielectric mold.

16. A vehicle having an antenna module mounted therein, the vehicle comprising:
an antenna module disposed below a roof of the vehicle; and
a processor disposed inside or outside the antenna module and configured to communicate with at least one of an adjacent vehicle, a road side unit (RSU), and a base station,
wherein the antenna module comprises:
a printed circuit board (PCB) on which electronic components are disposed;
an antenna element connected to a metal pattern on the PCB and configured to radiate a radio signal;
a lower cover disposed below the PCB and made of a metal plate; and
an upper cover combined with the lower cover and configured to accommodate the PCB and the antenna element therein;
the antenna element further comprises:
a first conductive part disposed to be perpendicular to the PCB within a predetermined angle range and having a first metal pattern in a loop shape; and
a second conductive part having a second metal pattern disposed at an upper end of the first metal pattern to be parallel with the PCB, and
the antenna element is configured to:
radiate a first signal in a first band through the second conductive part, and
radiate a second signal in a second band other than the first band through the first conductive part.

17. The vehicle of claim 16, wherein the antenna element further comprises:
a feeding structure configured to extend from an upper end of a first separation point of a lower pattern of the first metal pattern to be connected to a signal pattern of the PCB; and
a short-circuit structure configured to extend from an upper end of a second separation point of the lower pattern of the first metal pattern to be connected to a ground pattern of the PCB, and
the feeding structure comprises:
a first feed pattern disposed to extend from the upper end of the first separation point of the lower pattern of the first metal pattern to be parallel with the PCB;
a second feed pattern disposed at an end of the first feeding pattern to be perpendicular to the first feed pattern; and
a third feed pattern disposed at an end of the second feed pattern to be perpendicular to the second feed pattern and configured to be connected to the signal pattern of the PCB.

18. The vehicle of claim 16, wherein the antenna element operates as a first antenna disposed on one side region of the PCB, and the second conductive part of the first antenna is disposed to be bent at an upper end of the first metal pattern in one direction,
the antenna element further comprises a second antenna disposed on another side region of the PCB to have a structure symmetrical to the first antenna, and
the second antenna comprises:
a first conductive part disposed to be perpendicular to the PCB within a predetermined angle range and configured to have a first metal pattern in a loop shape; and
a second conductive part disposed to be bent at an upper end of the first metal pattern in another direction opposite to the one direction and having a second metal pattern to be parallel with the PCB.

19. The vehicle of claim 11, wherein the processor is disposed on the PCB to be adjacent to the first antenna and operably coupled to the first antenna and the second antenna, and
when quality of a signal received from the first antenna is equal to or less than a threshold value, the processor applies a signal to the second antenna to receive a signal through the second antenna.

20. The vehicle of claim 19, wherein the processor is configured to:
perform multiple input/output (MIMO) or diversity operation in the first band through the first antenna and the second antenna, and
perform MIMO or diversity operation in the second band higher the first band through the first antenna and the second antenna, when quality of the first signal in the first band is equal to or below a threshold value.
